# EUROPEAN PATENT SPECIFICATION

(11) **EP 1 261 761 B1**
(45) Date of publication and mention of the grant of the patent: **17.05.2006**
(21) Application number: 00985973.7
(22) Date of filing: 28.12.2000
(51) Int. Cl.: C30B 35/00, C03B 20/00, C30B 31/10

(54) **QUARTZ MEMBER FOR SEMICONDUCTOR MANUFACTURING EQUIPMENT AND METHOD FOR METAL ANALYSIS IN QUARTZ MEMBER**
QUARZGLASBAUTEIL FÜR HALBLEITERHERSTELLUNGSANLAGE UND VERFAHREN ZUR METALLUNTERSUCHUNG IN EINEM QUARZGLASBAUTEIL
ELEMENT A QUARTZ POUR MATERIEL DE FABRICATION DE SEMI-CONDUCTEUR ET PROCEDE D'ANALYSE DE METAL DANS UN ELEMENT A QUARTZ

(30) Priority: 07.02.2000 JP 2000029807
(43) Date of publication of application: 04.12.2002
(73) Proprietor: TOKYO ELECTRON LIMITED, Minato-ku, Tokyo 107-0052 (JP)
(72) Inventor: MARUMO, Yoshinori, Tokyo Electron Limited, Nirasaki-shi, Yamanashi 407-0192 (JP); SUZUKI, Kaname, Tokyo Electron Limited, Nirasaki-shi, Yamanashi 407-0192 (JP); HAYASHI, Teruyuki, Tokyo Electron Limited, Nirasaki-shi, Yamanashi 407-0192 (JP); TANAHASHI, Takashi, Tokyo Electron Tohoku Limited, Tsukui-gun, Kanagawa 220-0101 (JP)
(74) Representative: Liesegang, Roland
(86) International application number: PCT/JP2000/009381
(87) International publication number: WO 2001/059189

(56) References cited:
- EP-A- 0 691 423
- DE-A- 19 918 001
- US-A- 5 749 723
- US-A- 5 968 259
- RUSH: "Tolerances dimensional parameters and care of clear fused quartz furnace tubes" SOLID STATE TECHNOLOGY., vol. 30, no. 8, 1987, pages 55-57, XP002166942 COWAN PUBL.CORP. WASHINGTON., US ISSN: 0038-111X
- SCHMIDT: "furnace contamination and its remedies" SOLID STATE TECHNOLOGY., vol. 26, no. 6, 1983, pages 147-151, XP002166943 COWAN PUBL.CORP. WASHINGTON., US ISSN: 0038-111X

## Description

### Technical Field

The present invention relates to quartz member for semiconductor manufacturing equipment, a manufacturing method of quartz member for semiconductor manufacturing equipment, thermal treatment equipment, and an analysis method of metal in quartz member. In particular, the present invention relates to quartz member for semiconductor manufacturing equipment suitable for heat treating semiconductor substrates such as silicon wafers, a manufacturing method of quartz member for semiconductor manufacturing equipment, thermal treatment equipment and a method for analyzing metal in quartz member.

### Prior Art

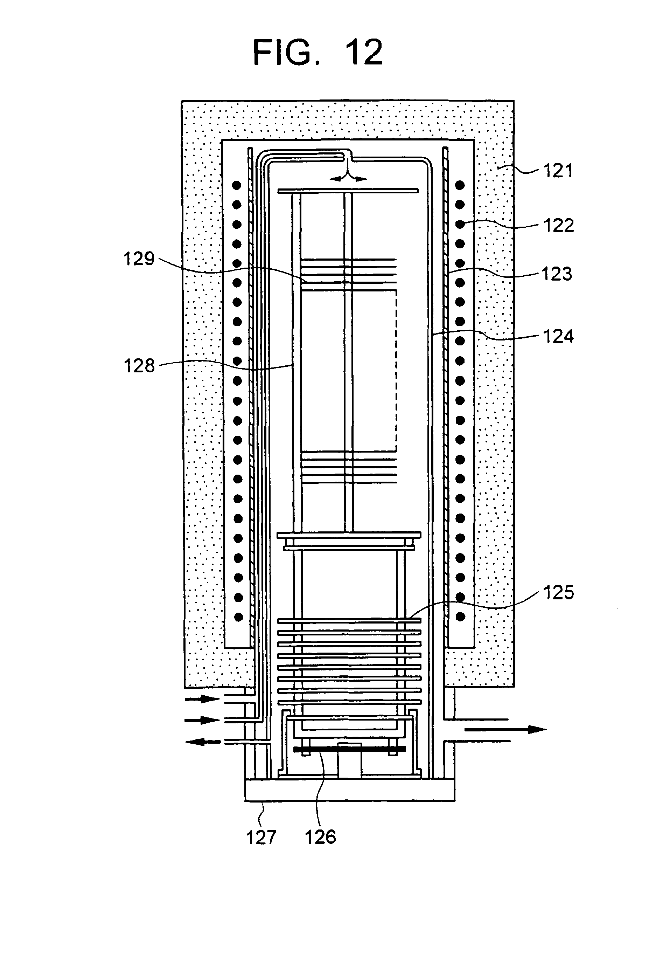

Thermal treatment equipment for heat treating semiconductor wafers accommodates therein a plurality of pieces of semiconductor wafers held in an approximately level state in thermal treatment equipment to heat by means of a heater. Fig. 12 is a vertical sectional view showing a rough configuration of typical thermal treatment equipment.

As shown in Fig. 12, a plurality of pieces of semiconductor wafers 129 are accommodated in the thermal treatment equipment. In the thermal treatment equipment, an almost cylindrical quartz tube, that is, a quartz glass furnace tube 124, is disposed. The semiconductor wafers 129 are accommodated in the quartz glass furnace tube 124 together with a wafer boat 128 holding the wafers 129 approximately level, in an almost vacuum state. The wafers 129 are heat-treated by heat from a heater 122 that is arranged so as to surround the quartz glass furnace tube 124.

In the drawing, a furnace cover 127 is a cover for carrying the semiconductor wafers 129 together with the wafer boat 128 in and out of the quartz glass furnace tube 124. A rotary table 126 rotates during heat treatment to improve uniformity of heat treatment of the semiconductor wafers 129 of the wafer boat 128. Furthermore, reflector plates 125 and a furnace liner tube 123 are disposed to make more uniform a temperature distribution in the thermal treatment equipment, an heat insulator 121 being disposed to cover an approximate entirety of the thermal treatment equipment to maintain heat therein.

The heater 122 includes metal atoms such as copper or the like, upon heating, the metal atoms diffusing from the heater 122 to deposit on a surface of the quartz glass furnace tube 124. The metal atoms deposited on the surface of the quartz glass furnace tube 124 diffuse in the quartz glass furnace tube 124 in a thickness (depth) direction to reach the inside of the quartz glass furnace tube 124. Therefrom, the metal atoms intrude into a space inside of the quartz glass furnace tube 124 and deposit on the semiconductor wafers 129 being heat treated to cause so-called contamination, thereby resulting in an occurrence of poor quality products.

Physical properties and compositions of the quartz glass furnace tube 124 are considered to have some relationship with diffusion and contamination of the metal. Accordingly, the physical properties and compositions of quartz material constituting the quartz glass furnace tube 124 are necessary to be controlled. In particular, a diffusion coefficient when the metal atoms diffuse through the quartz glass is an indicator in grasping a diffusion speed of a contaminant. Accordingly, accurate knowledge of the diffusion coefficient is important.

However, data, which are supplied from manufacturers of the quartz glass furnace tubes, of the diffusion coefficient of quartz materials configuring the quartz glass furnace tubes scatter largely dependent on manufacturers thereof. Between the manufacturers compared, there is a difference in data of as much as approximately 10⁵ times at maximum. Accordingly, there is a problem in impartially judging quality of the quartz glass furnace tube that is a product in terms of the data of the diffusion coefficients supplied from the manufacturers.

Furthermore, in existing methods, the diffusion coefficients of the quartz glass furnace tubes are measured by means of SIMS method (Secondary Ion Mass Spectroscopy method) or an optical method. However, in the SIMS method, a detection lower limit is extremely coarse as 4.8µg/g, an analysis area (depth) being small as approximately 200 µm. Accordingly, there are problems that measurement capacity is poor, measurement accuracy being low, investment being large, cost for one measurement being high.

On the other hand, in the optical method, a depth resolution is too thick as 500µm, the detection lower limit being approximately 10 ng/g. As a result, both the measurement capacity and measurement accuracy can not be sufficiently satisfied.

### DISCLOSURE OF THE INVENTION

The present invention is carried out to overcome the aforementioned existing problems. That is, the object of the present invention is to provide quartz member such as a quartz tube for semiconductor manufacturing equipment, a manufacturing method of such quartz member, thermal treatment equipment provided with such quartz member, and an analysis method of copper in the quartz member. The quartz member such as a quartz tube for semiconductor manufacturing equipment can be heat treated without causing contamination of the substrates to be treated.

To attain the aforementioned object, quartz member for semiconductor manufacturing equipment involving the present invention is formed of quartz material having a metal diffusion region of a depth of 200 µm or more of which the copper diffusion coefficient D is 5.8E-10 cm²/s or less. The copper diffusion coefficient is obtained by the use of an analysis method of copper in the quartz material. The analysis method comprises the steps of exposing a layer to be analyzed, chemically decomposing, analyzing an amount of copper, and obtaining a volume of the layer to be analyzed. In the step of exposing the layer to be analyzed, the layer to be analyzed at a desired depth in a quartz specimen is exposed. In the step of chemically decomposing the layer to be analyzed to separate, after the chemical decomposition of the layer to be analyzed, a decomposition product is separated from the quartz specimen. In the step of analyzing an amount of copper, the amount of copper in the separated decomposition product is analyzed.

In the step of obtaining a volume of the layer to be analyzed, the volume of the layer to be analyzed is obtained from a volume change between the quartz specimens before the decomposition of the layer to be analyzed and after the separation of the decomposition product.

Furthermore, a manufacturing method of quartz member for semiconductor manufacturing equipment involving the present invention comprises the steps of forming quartz material so as to comprise 200 µm or more of a metal diffusion region of which the copper diffusion coefficient D is 5.8E-10 cm²/s or less, and of molding the quartz material formed in tube. The copper diffusion coefficient is obtained by the use of an analyses method of metal in quartz material. The analyses method comprises a first step of exposing a layer to be analyzed, a second step of chemically decomposing, a third step of analyzing an amount of copper, and a fourth step of obtaining a volume of the layer to be analyzed. In the step of exposing the layer to be analyzed, the layer to be analyzed at a desired depth in a quartz specimen is exposed. In the step of chemically decomposing the layer to be analyzed to separate, after the chemical decomposition of the layer to be analyzed, a decomposition product is separated from the quartz specimen. In the step of analyzing an amount of copper, the amount of copper in the separated decomposition product is analyzed. In the step of obtaining a volume of the layer to be analyzed, the volume of the layer to be analyzed is obtained from a volume change between the quartz specimens before the decomposition of the layer to be analyzed and after the separation of the decomposition product.

Still further, thermal treatment equipment involving the present invention comprises a body, a quartz tube, a heater, gas feed unit, and a holding means. Here, the body defines a cylindrical heat treatment space extended in up and down directions. The quartz tube is disposed in the heat treatment space and accommodates a substrate to be treated, being constituted of quartz material having a metal diffusion region of a depth of 200 µm or more of a metal diffusion region of which the copper diffusion coefficient D is 5.8E-10 cm²/s or less. The heater heats an exterior surface of the quartz tube. The gas feed unit feeds gas in the aforementioned quartz tube. The holding means holds removably a plurality of substrates to be treated that are held mutually level.

Furthermore, an analysis method of metal in quartz member involving the present invention is one that analyzes copper in the quartz member to obtain a diffusion coefficient thereof. The present analysis method comprises the steps of exposing a layer to be analyzed, chemically decomposing, analyzing an amount of copper, and obtaining a volume of the layer to be analyzed. In the step of exposing the layer to be analyzed, the layer to be analyzed at a desired depth in a quartz specimen is exposed. In the step of chemically decomposing the layer to be analyzed to separate, after the chemical decomposition of the layer to be analyzed, a decomposition product is separated from the quartz specimen. In the step of analyzing an amount of copper, the amount of copper in the separated decomposition product is analyzed.

In the step of obtaining a volume of the layer to be analyzed, the volume of the layer to be analyzed is obtained from a volume change between the quartz specimens before the decomposition of the layer to be analyzed and after the separation of the decomposition product.

Furthermore, an analysis method of metal in quartz member involving the present invention is one that analyzes copper in the quartz member to obtain a diffusion coefficient thereof. The present analysis method comprises a first step of exposing a layer to be analyzed, a second step of chemically decomposing the layer to separate, a third step of analyzing an amount of copper, a fourth step of obtaining a volume of the layer, a fifth step of exposing a new layer to be analyzed, and a sixth step of obtaining a concentration distribution of the copper. In the first step of exposing the layer to be analyzed, the layer to be analyzed at a desired depth in a quartz specimen is exposed. In the second step of chemically decomposing the layer to separate, after the decomposition, a decomposition product is separated from the quartz specimen. In the third step of analyzing an amount of copper, the amount of the copper in the separated decomposition product is analyzed. In the fourth step of obtaining a volume of the layer, the volume of the layer to be analyzed is obtained from a volume change between the quartz specimens before the decomposition of the layer to be analyzed and after the separation of the decomposition product. In the fifth step of exposing a new layer to be analyzed, a layer further inside in a depth direction than the layer to have been analyzed is exposed. In the sixth step of obtaining a concentration distribution of the copper, the aforementioned second through fifth steps are repeated to obtain a concentration distribution of the copper diffused in a depth direction of the quartz specimen.

In the present invention, a surface of the quartz specimen is divided into thin layers to be analyzed, followed by chemically analyzing the respective layers. Accordingly, analysis results of high accuracy can be obtained and the diffusion coefficients of high reliability can result. Thereby, with the material of small diffusion coefficient, a quartz member can be manufactured for semiconductor manufacturing equipment. Accordingly, the quartz member used for semiconductor manufacturing equipment capable of heat treating the semiconductor wafers without contaminating can be obtained.

### Brief Explanation of the Drawings

Fig. 1 is a flowchart showing a flow of an analysis method involving the present invention.
Fig. 2 is a diagram schematically showing circumstances when implementing an analysis method involving the present invention.
Fig. 3 is a flowchart showing a flow of an analysis method involving the present invention, different from one shown in Fig. 1.
Fig. 4 is a diagram schematically showing circumstances when implementing an analysis method involving the present invention, different from one shown in Fig. 2.
Fig. 5 is a diagram showing results of reproducibility verification test of an analysis method involving the present invention.
Figs. 6A and 6B are diagrams showing cross contamination verification test of an analysis method involving the present invention and results thereof.
Fig. 7 compares an analysis method involving the present invention and an existing analysis method to show differences thereof.
Fig. 8 is a diagram showing groupings of quartz due to manufacturing methods and differences of the quartz.
Fig. 9 is a flowchart showing a flow of a manufacturing method of a quartz tube involving the present invention.
Fig. 10, a continuation of Fig. 9, is a flowchart showing a flow of a manufacturing method of a quartz tube involving the present invention.
Fig. 11 is a sectional view of thermal treatment equipment showing one embodiment of the present invention.
Fig. 12 is a vertical sectional view of representative thermal treatment equipment.

### The Best Modes for implementing the present Invention

As a preferable mode of implementing the present invention, in claim 1, the diffusion coefficients are analyzed due to an analysis method of metal in quartz member. The method thereof comprises the steps of exposing a layer to be analyzed, chemically decomposing the layer to separate, analyzing an amount of copper and obtaining a volume of the layer to be analyzed. In the step of exposing the layer to be analyzed; a layer to be analyzed at a desired depth in a quartz specimen is exposed. In the step of chemically decomposing the layer to separate, after the chemical decomposition, a decomposition product is separated from the quartz specimen. In the step of analyzing an amount of copper the amount of copper in the separated decomposition product is analyzed. In the step of obtaining a volume of the layer to be analyzed, the volume of the layer to be analyzed is obtained from a volume change between the quartz specimens before the decomposition of the layer to be analyzed and after the separation of the decomposition product.

Furthermore, as a preferable mode of implementing the present invention, in claim 2, the step of obtaining the volume of the layer to be analyzed in the aforementioned analysis method is carried out as follows. That is, a change in thickness between the quartz specimens before the decomposition of the layer to be analyzed and after the separation of the decomposition product is calculated into a volume of the layer to be analyzed.

Furthermore, as a preferable mode of implementing the present invention, in claim 3, the step of obtaining the volume of the layer to be analyzed in the aforementioned analysis method is carried out as follows. That is, a change in weight between the quartz specimens before the decomposition of the layer to be analyzed and after the separation of the decomposition product is calculated into a volume of the layer to be analyzed.

As a preferable mode of implementing the present invention, the diffusion coefficient is analyzed due to an analysis method of metal in quartz member. The analysis method comprises a first step of exposing a layer to be analyzed, a second step of chemically decomposing the layer to separate, a third step of analyzing an amount of copper a fourth step of obtaining a volume of the layer, a fifth step of exposing anew a layer to be analyzed, and a sixth step of obtaining a concentration distribution of the diffused metal. In the first step of exposing the layer to be analyzed, the layer to be analyzed at a desired depth in a quartz specimen is exposed. In the second step of chemically decomposing the layer to separate, after the chemical decomposition of the layer, a decomposition product is separated from the quartz specimen. In the third step of analyzing an amount of metal, the amount of metal in the separated decomposition product is analyzed. In the fourth step of obtaining a volume of the layer, the volume of the layer to be analyzed is obtained from a volume change between the quartz specimens before the decomposition of the layer to be analyzed and after the separation of the decomposition product. A further preferred implementation of the invention comprises a fifth step of exposing anew a layer to be analyzed, a layer to be analyzed furthermore inside in a direction of a thickness than the layer to have been analyzed is exposed. In a sixth step of obtaining a concentration distribution of the diffused metal, the second to fifth steps are repeated to obtain the concentration distribution of the metal diffused in a thickness direction of the quartz specimen.

Furthermore, as a preferable embodiment of the present invention, the step of exposing the layer to be analyzed in the aforementioned analysis method is one in which a surface of the quartz specimen is etched by use of hydrofluoric acid.

Still furthermore, as a preferable embodiment of the present invention, in claim 5, the first and/or fifth step of exposing the layer to be analyzed in the aforementioned analysis method is one in which a surface of the quartz specimen is etched by use of hydrofluoric acid.

Furthermore, as a preferable embodiment of the present invention, the step of chemically decomposing the layer to be analyzed to separate a decomposition.product from the quartz specimen in the aforementioned analysis.method comprises the following steps. That is, a step of dripping a decomposition liquid, a step of keeping the dripped decomposition liquid in contact with the quartz specimen, and a step of recovering the decomposition liquid are comprised. Here, in the step of dripping a decomposition liquid, the decomposition liquid is dripped on an exposed surface of the layer to be analyzed. In the step of keeping the dripped decomposition liquid in contact with the quartz specimen, the dripped decomposition liquid is kept in contact with the quartz specimen for a prescribed period to decompose the layer to be analyzed. In the step of recovering the decomposition liquid, the decomposition liquid containing the decomposed layer to be analyzed is recovered.

Furthermore, as a preferable mode of implementing the present invention, in claim 6, the second step of chemically decomposing the layer to be analyzed to separate a decomposition product from the quartz specimen in the aforementioned analysis method comprises the following steps. That is, the steps of dripping decomposition liquid, keeping the dripped decomposition liquid in contact with the quartz specimen, and recovering the decomposition liquid are comprised. Here, in the step of dripping the decomposition liquid, the decomposition liquid is dripped on a surface of the exposed layer to be analyzed. In the step of keeping the dripped decomposition liquid in contact with the quartz specimen, the dripped decomposition liquid is kept in contact with the quartz specimen for a prescribed period to decompose the layer to be analyzed. In the step of recovering the decomposition liquid, the decomposition liquid containing the decomposed layer to be analyzed is recovered.

Furthermore, as a preferable mode of implementing the present invention, in claim. 7, the decomposition liquid is hydrofluoric acid alone, or a mixed liquid of hydrofluoric acid and at least one or more selected from a group of nitric acid, hydrochloric acid, sulfuric acid, and hydrogen peroxide,

Still further, as a preferable mode of implementing the present invention, : the step of analyzing an amount of copper in the separated decomposition product in the aforementioned analysis method is implemented by the use of one of the following methods. That is, atomic absorption spectroscopy, inductively coupled plasma atomic emission spectroscopy, or induction coupled plasma mass spectroscopy is used.

Furthermore, as a preferable mode of implementing the present invention, in claim 8, the third step of analyzing an amount.of copper in the separated decomposition product in the aforementioned analysis method is implemented by the use of one of the following methods. That is, atomic absorption spectroscopy, inductively coupled plasma atomic emission spectroscopy, or induction coupled plasma mass spectroscopy is used.

Furthermore, as a preferable mode of implementing the present invention, in claim 9, 60 µg/g or less of hydroxy group is preferably contained in the quartz member.

Furthermore, as a preferable mode of implementing the present invention, in claim 10, the quartz member is subjected to heat treatment preferably at a temperature in the range of 1050 to 1500 °C.

Furthermore, as a preferable mode of implementing the present invention, in claim 11, the quartz member possesses a density in the range of 2.2016 to 2.2027 g/cm³.

Furthermore, as a preferable mode of implementing the present invention, in claim 12, the quartz member contains 5 ng/g or less of copper.

Furthermore, as a preferable mode of implementing the present invention, in claim 1, the quartz member is formed by means of an electric melting process.

Furthermore, as a preferable mode of implementing the present invention, in claim 1, the quartz member is preferably used for a quartz glass furnace tube.

Furthermore, as a preferable mode of implementing the present invention, in claim 20, the diffusion coefficient is obtained by the use of an analysis method of metal in quartz member. The analysis method comprises the steps of exposing a layer to be analyzed, chemically decomposing the layer to separate, analyzing an amount of metal, and obtaining a volume of the layer. In the step of exposing the layer to be analyzed, the layer to be analyzed at a desired depth in a quartz specimen is exposed. In the step of chemically decomposing the layer to separate, after the chemical decomposition, a decomposition product is separated from the quartz specimen. In the step of analyzing an amount of metal, the amount of metal in the separated decomposition product is analyzed. In the step of obtaining a volume of the layer, the volume of the layer to be analyzed is obtained from a volume change between the quartz specimens before the decomposition of the layer to be analyzed and after the separation of the decomposition product.

As a preferable mode of implementing the present invention, in claim 20, the diffusion coefficient is analyzed by the use of an analysis method of metal in quartz member. The analysis method comprises a first step of exposing a layer to be analyzed, a second step of chemically decomposing the layer to separate, a third step of analyzing an amount of copper, a fourth step of obtaining a volume of the layers a fifth step of exposing anew a layer to be analyzed, and a sixth step of obtaining a concentration distribution of diffused copper. In the first step of exposing the layer to be analyzed, the layer to be analyzed at a desired depth in a quartz specimen is exposed. In the second step of chemically decomposing the layer to separate, after the chemical decomposition of the layer, a decomposition product is separated from the quartz specimen. In the third step of analyzing an amount of copper the amount of copper in the separated decomposition product is analyzed. In the fourth step of obtaining a volume of the layer, the volume of the layer is obtained from a volume change between the quartz specimens before the chemical decomposition of the layer and after the separation of the decomposition product. In the fifth step of exposing a layer to be analyzed, a layer to be analyzed furthermore inside in a thickness direction than the layer to have been analyzed is exposed. In the sixth step of obtaining a concentration distribution of diffused metal, the second to fifth steps are repeated to obtain the concentration distribution of the metal diffused in a thickness direction of the quartz specimen.

Furthermore, as another preferable mode of implementing the present invention, the diffusion coefficient is obtained by the use of an analysis method of metal in quartz member. The analysis method comprises the steps of exposing a layer to be analyzed, chemically decomposing the layer to separate, analyzing an amount of copper, and obtaining a volume of the layer. In the step of exposing a layer to be analyzed, the layer to be analyzed at a desired depth in the quartz specimen is exposed. In the step of chemically decomposing the layer to separate, after the chemical decomposition, a decomposition product is separated from the quartz specimen. In the step of analyzing an amount of copper the amount of copper in the separated decomposition product is analyzed. In the step of obtaining a volume of the layer, the volume of the layer is obtained from a volume change-between the quartz specimens before the chemical decomposition of the layer and after the separation of the decomposition product.

As a preferable mode of implementing the present invention, the diffusion coefficient is obtained by the use of an analysis method of metal in quartz member. The analysis method comprises a first step of exposing a layer to be analyzed, a second step of chemically decomposing the layer to separate, a third step of analyzing an amount of copper a fourth step of obtaining a volume of the layer, a fifth step of exposing anew a layer to be analyzed, and a sixth step of obtaining a concentration distribution of diffused copper In the first step of exposing a layer to be analyzed, the layer at a desired depth in a quartz specimen is exposed. In the second step of chemically decomposing the layer to separate, after the chemical decomposition of the layer, a decomposition product is separated from the quartz specimen. In the third step of analyzing an amount of copper the amount of copper in the separated decomposition product is analyzed. In the fourth step of obtaining a volume of the layer, the volume of the layer is obtained from a volume change between the quartz specimens before the chemical decomposition of the layer and after the separation of the decomposition product. In the fifth step of exposing anew a layer to be analyzed, the layer to be analyzed furthermore inside in a thickness direction than the layer to have been analyzed is exposed. In the sixth step of obtaining a concentration distribution of diffused metal, the second to fifth steps are repeated to obtain the concentration distribution of the metal diffused in a thickness direction of the quartz specimen.

Still furthermore, as a further preferable embodiment of the present invention, the step of obtaining the volume of the layer to be analyzed can be implemented as follows. That is, the volume of the layer to be analyzed is calculated from a thickness change between the quartz specimens before the chemical decomposition of the layer to be analyzed and after the separation of the decomposition product.

Furthermore, as another preferable embodiment of the present invention, the step of obtaining the volume of the layer to be analyzed can be implemented as follows. That is; the volume of the layer to be analyzed is calculated from a weight change between the quartz specimens before the chemical decomposition of the.layer to be analyzed and after the separation of the decomposition product.

Still furthermore, as a preferable embodiment of the present invention, the step of exposing the layer to be analyzed is one in which a surface of the quartz specimen is etched by hydrofluoric acid.

Furthermore, as a preferable embodiment of the present invention, the first and/or fifth step of exposing the layer to be analyzed is one in which a surface of the quartz specimen is etched by hydrofluoric acid.

Still furthermore, as a preferable mode of implementing the present invention, the step of chemically decomposing the layer to be analyzed to separate a decomposition product from the quartz specimen comprises the following steps. That is, a step of dripping a decomposition liquid, a step of keeping the dripped decomposition liquid in contact with the quartz specimen, and a step of recovering the decomposition liquid are comprised. Here, in the step of dripping a decomposition liquid, the decomposition liquid is dripped on a surface of the exposed layer to be analyzed. In the step of keeping the dripped decomposition liquid in contact with the quartz specimen, the dripped decomposition liquid is kept for a prescribed period in contact with the quartz specimen to decompose the layer to be analyzed. In the step of recovering the decomposition liquid, the decomposition liquid containing the decomposed layer to be analyzed is recovered.

Furthermore, as a preferable embodiment of the present invention, the second step of chemically decomposing the layer to be analyzed to separate a decomposition product from the quartz member comprises the following steps. That is, the steps of dripping a decomposition liquid, keeping the dripped decomposition liquid in contact with the quartz specimen, and recovering the decomposition liquid are comprised. Here, in the step of dripping a decomposition liquid, the decomposition liquid is dripped on a surface of the exposed layer to be analyzed. In the step of keeping the dripped decomposition liquid in contact with the quartz specimen, the dripped decomposition liquid is kept in contact with the quartz specimen for a prescribed period to decompose the layer to be analyzed. In the step of recovering the decomposition liquid, the decomposition liquid containing the decomposed layer to be analyzed is recovered.

Still furthermore, as a preferable mode of implementing the present invention, the decomposition liquid is hydrofluoric acid alone, or a mixed liquid of hydrofluoric acid and at least one or more selected from a group of nitric acid, hydrochloric acid, sulfuric acid, and hydrogen peroxide.

Still further, as a preferable mode of implementing the present invention, the step of analyzing an amount of copper in the separated decomposition product is implemented by the use of atomic absorption spectroscopy, inductively coupled plasma atomic emission spectroscopy, or inductively coupled plasma mass spectroscopy.

Furthermore, as a preferable mode of implementing the present invention, in claim 29, the third step of analyzing an amount of metal in the separated decomposition product is implemented by the use of atomic absorption spectroscopy, inductively coupled plasma atomic emission spectroscopy, or inductively coupled plasma mass spectroscopy.

In the following, embodiments of the present invention will be explained with reference to the drawings. (First Embodiment)

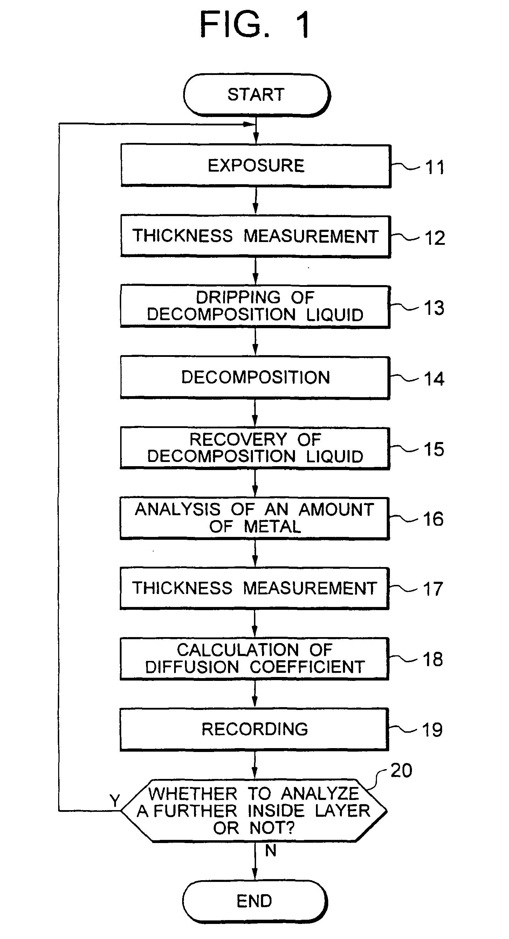

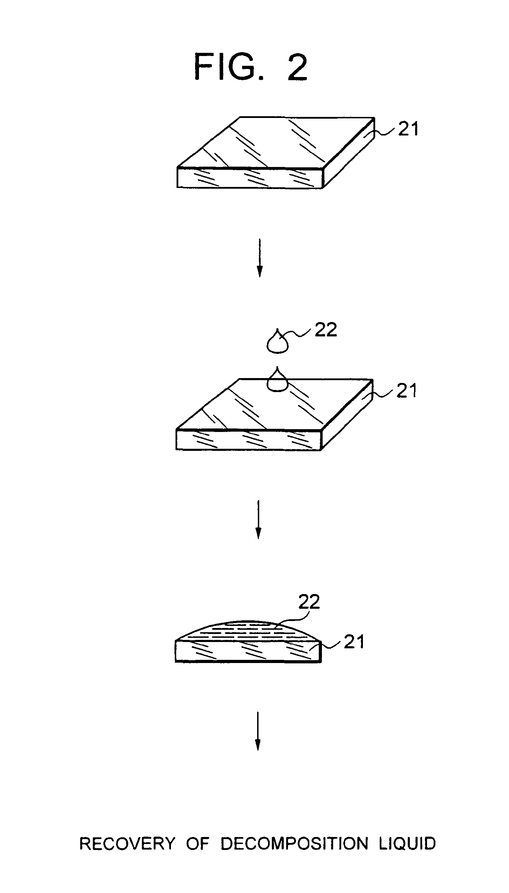

Fig. 1 is a flowchart showing a flow of an analysis method involving one embodiment, Fig. 2 being a diagram schematically showing circumstances in implementing the above method.

In implementing an analysis method involving the present invention, first a specimen 21 of for instance rectangle or square is prepared. The specimen 21 is immersed in a surface treatment liquid, hydrofluoric acid (HF) for instance, to etch a surface thereof 21. The etched surface is a surface of a layer to be analyzed. For instance a surface of a layer of a depth of 10 µm from the surface of the specimen 21 is exposed (step 11). At that time, a thickness of a layer to be etched can be controlled by appropriately adjusting the conditions such as a concentration of the treatment liquid such as hydrofluoric acid, an etching period during and a temperature at which the etching is implemented. Furthermore, hydrofluoric acid may be used in any one of liquid and gaseous (vapor) forms.

Next, the specimen 21 is taken out of hydrofluoric acid, followed by cleaning and drying, thereafter a thickness of the specimen 21 is measured (step 12). In measuring the thickness, various kinds of known measuring methods that use a micrometer or electromagnetic waves may be used. Thus obtained thickness is recorded as for instance dn.

Next, on a single surface of the specimen 21, as a decomposition liquid 22 a mixed liquid of for instance hydrofluoric acid and nitric acid is dripped (step 13). At that time, the decomposition liquid 22 may be hydrofluoric acid alone, or a mixed liquid of hydrofluoric acid and other acid, for instance one or more of nitric acid, hydrochloric acid and sulfuric acid, or a mixed liquid of hydrofluoric acid and hydrogen peroxide, or a mixed liquid of hydrofluoric acid and hydrogen peroxide and other acid, for instance one or more of nitric acid, hydrochloric acid and sulfuric acid.

From a viewpoint of easiness to dissolve metal atoms in quartz into the decomposition liquid 22, a mixed liquid of hydrofluoric acid and nitric acid is preferably used.

A composition and concentration of the decomposition liquid 22, and a mixing ratio in the mixed liquid are preferably adjusted to values appropriate for decomposing a surface of quartz of the specimen 21 by 10 µm per approximate 30 min for instance.

After dripping the decomposition liquid 22, while maintaining at an appropriate temperature as it is, a surface of the quartz specimen 21 is decomposed by a very thin layer, for instance a layer of a thickness of approximately 10 µm (step 14).

At that time, the decomposition liquid 22, owing to its 22 own surface tension, is held on the specimen 21 to enable to dispense with a cap or container. Accordingly, during the decomposition, a substance attached to a container does not contaminate the decomposition liquid 22, or an amount thereof does not vary as the result of sticking to the cap. Here, an area S in which the decomposition liquid 22 spreads out is measured, or in the range of a known area S the decomposition liquid 22 is spread out and held.

Though the period and conditions when holding the decomposition liquid 22 are design matter, it is preferable to adjust so that a surface of quartz of a thickness of approximately 10 µm is decomposed in for instance 30 min.

Next, after the prescribed period passed to completely decompose, the decomposition liquid 22 is recovered (step 15).

Thus obtained decomposition liquid 22 is subjected to a quantitative analysis equipment, metal contained in the decomposition liquid 22, for instance an amount of copper being analyzed (step 16). For the quantitative analysis equipment used at that time, though whatever apparatuses can be used, typically, for instance an atomic absorption spectroscopy (AAS) or an ICP-AES (Inductively Coupled Plasma Atomic Emission Spectroscopy), and an ICP-MS (Inductively Coupled Plasma Mass Spectroscopy) may be employed. Thus obtained amount of metal is recorded as for instance Cn.

Next, a thickness of the quartz specimen 21 of which surface was decomposed in the aforementioned step 14 is measured by the use of the method similar with that in the step 12 (step 17). Thus obtained thickness of the specimen 21 is recorded as dₙ₊₁.

Next, a concentration of metal in the layer to be analyzed is obtained from data obtained as mentioned above. That is, from the thicknesses dn and dₙ₊₁ of the specimen 21 obtained in the steps 12 and 17, a thickness of the layer to be analyzed is obtained. Thus obtained thickness is multiplied by the area S obtained in the step 14 to result in a volume Vn of the layer to be analyzed. In the volume Vn, the metal of the amount Cn obtained in the step 16 is contained. Accordingly, a concentration of metal contained in the layer to be analyzed can be obtained from Cn/Vn.

Given the concentrations of metal, a diffusion coefficient D of the layer to be analyzed can be obtained from Fick's second law ∂C/∂t = D · ∂²C/∂X², as ln C = - X²/4Dt + A. (In the equations, C: a concentration of metal at a depth X (atoms/cm³), D: a diffusion coefficient (cm²/s), X: depth (cm), t: diffusion time period (sec), A: constant). By solving the above equation, the diffusion coefficient D can be obtained (step 18). The obtained diffusion coefficient is recorded as Dn (step 19).

Following this, whether a further inside layer is necessary to analyze quantitatively as a layer to be analyzed or not is judged (step 20). When the further quantitative analysis being judged necessary, returning to the step 11, with hydrofluoric acid, for the further inside layer too, similarly the steps from 11 to 19 are repeated to obtain a diffusion coefficient Dₙ₊₁.

After that, the steps 11 through 20 are similarly repeated to analyze thin layers to be analyzed of a thickness of approximately 10 µm consecutively from outside to inside of the quartz specimen 21, the respective diffusion coefficients D₁, D₂, D₃, ---, Dₙ, Dₙ₊₁, Dₙ₊₂, --- Dₓ being obtained and recorded. Upon completion of the quantitative analysis of the innermost side of the layer to be analyzed, all the analysis operations are over.

As explained in the above, according to the analysis method involving the present embodiment, with hydrofluoric acid a surface of a layer to be analyzed at a desired depth is exposed, and thereafter an amount of metal in the layer to be analyzed is analyzed. Accordingly, a metal content at an arbitrary depth of the quartz specimen 21, in its turn a diffusion coefficient in the arbitrary layer, can be analyzed.

Furthermore, with the decomposition liquid a layer to be analyzed is decomposed to analyze. Accordingly, a very thin layer can be analyzed.

Still furthermore, a decomposition liquid 22 is held on a specimen 21 by its own 22 surface tension. Accordingly, during decomposition, a contaminant is very low in intruding into the decomposition liquid 22.

Furthermore, the specimen 21 is analyzed in liquid with decomposition liquid. Accordingly, a shape of the specimen 21 is large in degree of freedom.

### (Example)

In the following, an example of the first embodiment of the present invention will be explained.

As a specimen for analysis experiment, a quartz specimen for analysis of depth×width×thickness = 20 mm×20 mm×4 mm was prepared. To investigate a state where copper atoms diffused in the quartz specimen, on a single surface of the specimen a solution of ionized copper of a concentration of 10 µg/g was coated. While maintaining a temperature of 1050 °C under an atmospheric pressure, in this state, the specimen was heated for 24 hours to diffuse copper atoms.

Next, the specimen, after cleaning the surface thereof, was immersed in hydrofluoric acid. Thereby, the outermost layer of a thickness of approximately 10 µm was etched to expose a surface of a layer necessary to analyze.

Next, after obtaining a thickness d1 of the specimen, a mixed liquid of 25 % hydrofluoric acid and 0.1 N nitric acid was prepared as a decomposition liquid, followed by dripping on the specimen. In this state, the decomposition liquid was held on a surface of the specimen by its own surface tension to decompose a layer to be analyzed. After the decomposition of approximately 30-min, the decomposition liquid was recovered. Thus, the decomposition liquid thought to contain copper was obtained.

The decomposition liquid thus recovered was subjected to atomic absorption spectroscopy (AAS), copper contained in the decomposition liquid 22 being quantitatively analyzed to obtain a copper content.

On the other hand, a thickness of the specimen after the decomposition by the decomposition liquid was measured to obtain a value of thickness d2.

The thickness d2 obtained by the later measurement was subtracted from the thickness d1 previously obtained to obtain a thickness of a layer to be analyzed.

Thereby, the diffusion coefficient of the decomposed layer was made calculable. In addition, due to the later further experiments, it was confirmed that a depth resolution when analyzed due to the present analysis method is approximately 10 µm, a lower detection limit of the metal contained in the quartz specimen being 2.8 ng/g.

### (Reproducibility Verification Experiment)

An experiment for verifying reproducibility involving the present invention was carried out.

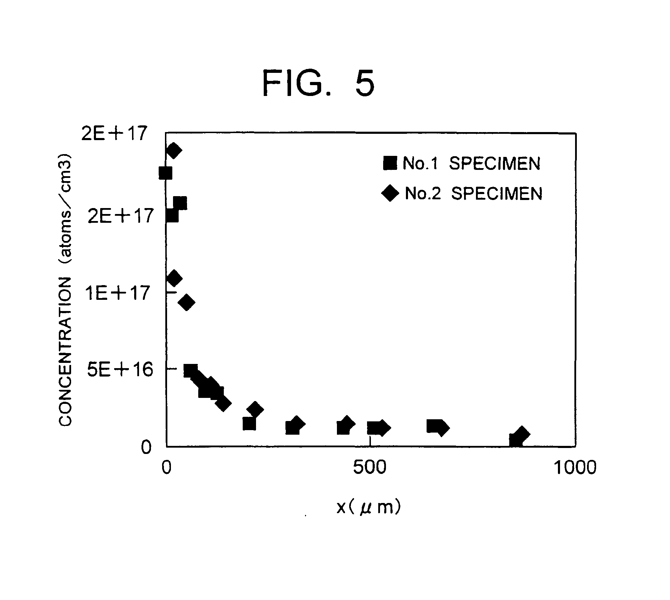

By the method similar with that of the above embodiment, two pieces of specimens ware prepared, being coated by a copper solution to prepare two forcedly contaminated specimens. With these specimens, operations similar with that of the aforementioned embodiment ware conducted to investigate a state of diffusion of copper (copper concentration). Results are shown in Fig. 5. An abscissa shows a distance (depth) from a surface of a quartz specimen, an ordinate showing a contained copper concentration. As obvious from the diagram, data of two specimens are very close, showing having high reproducibility.

### (Cross Contamination Verification Experiment)

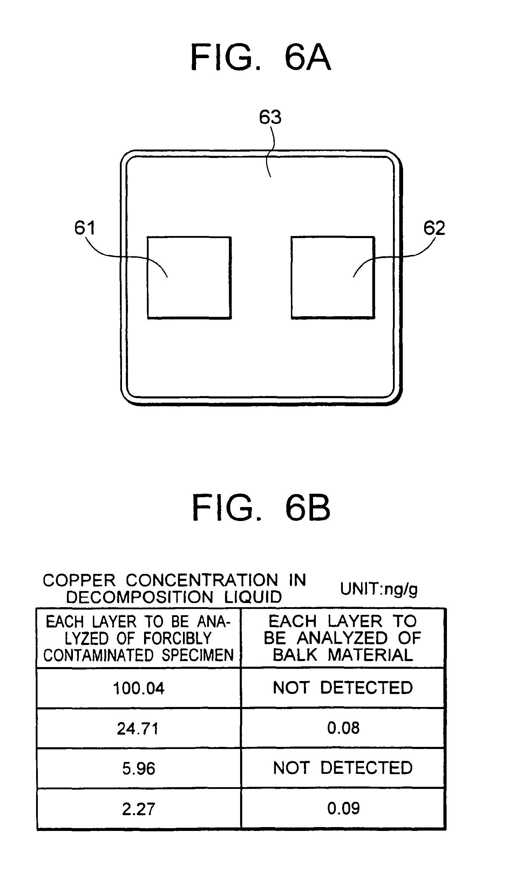

Next, a cross contamination verification experiment of the present analysis method was carried out. This will be explained with reference to Figs. 6A and 6B. For the present experiment, a specimen prepared in the similar way with the aforementioned embodiment (forcedly contaminated specimen 61) and a specimen that is not coated by the copper solution, the quartz specimen as it is (bulk material 62) ware prepared. These two specimens 61 and 62 ware accommodated in the same treatment space 63, with the treatment space 63 under an atmosphere of 50 % hydrofluoric acid, being maintained in this state for a definite period.

The copper concentrations of the respective layers to be analyzed of the forcedly contaminated specimen 61 and bulk material 62 ware analyzed to investigate an influence on the bulk material 62. Here, the copper concentrations of the respective analysis layers ware analyzed for the respective analysis layers similarly with the aforementioned embodiment, being obtained as the copper concentrations of the respective decomposition liquids. The results are shown in Fig.6B.

As shown in Fig. 6B, the bulk material 62 is hardly contaminated by copper to show no influence. That is, it is shown that the copper dissolved in the decomposition liquid does not diffuse again into the specimen, amounts of copper analyzed of the respective layers to be analyzed reflecting extremely accurately a state of copper diffusion.

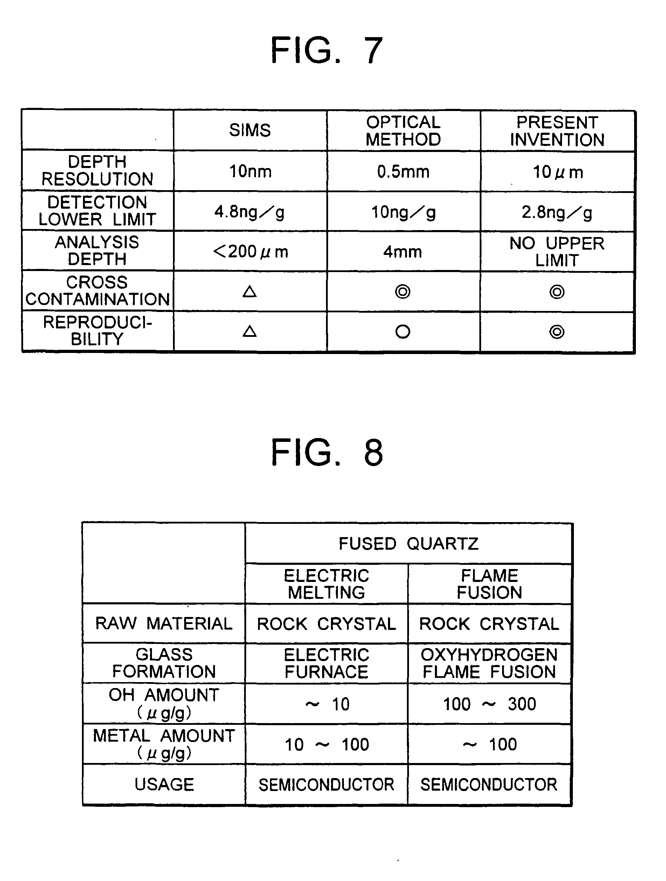

The aforementioned analysis method involving the present invention is compared with an existing one in Fig. 7. As shown in Fig. 7, the present invention is confirmed to be superior in the lower detection limit, resolvable region (depth), cross contamination and reproducibility, to the existing method.

As a result, according to the present invention, the diffusion coefficient of high reliability can be obtained by the use of the analysis method of high accuracy. Accordingly, with the diffusion coefficient, quality of the quartz material can be differentiated, thus enabling to obtain a quartz tube through which copper diffuses with difficulty.

That is, the surface of the quartz specimen is divided into thin layers to be analyzed, the layers to be analyzed each being chemically analyzed. Accordingly, an analysis result of high accuracy can be obtained, resulting in a diffusion coefficient of high reliability.

Furthermore, the same specimen is separated, from the outside thereof toward the inside, into many adjacent layers, the adjacent layers each being chemically analyzed. Accordingly, the circumstances where metal atoms diffuse can be verified in detail, resulting in obtaining the diffusion coefficient of high accuracy.

In addition, the layer to be analyzed is exposed by the use of a chemical method due to acid treatment, only a very surface of the quartz specimen being decomposed by the use of the decomposition liquid to analyze. Accordingly, a very thin layer to be analyzed at an arbitrary depth can be analyzed as analysis unit, a distribution of the diffusion coefficients in the quartz specimen being able to analyze in a thickness direction.

Furthermore, since the decomposition liquid is held owing to the surface tension of its own, contaminants from the container or the like can be suppressed to the minimum from mingling, resulting in the analysis of high accuracy.

In Fig. 8, classification of quartz due to manufacturing methods and differences of characteristics of the quartz are shown. As shown in Fig. 8, the quartz due to electric melting process is slight in amounts of both OH and metal, being considered to be the most suitable as material used in semiconductor manufacturing equipment.

### (Second Embodiment)

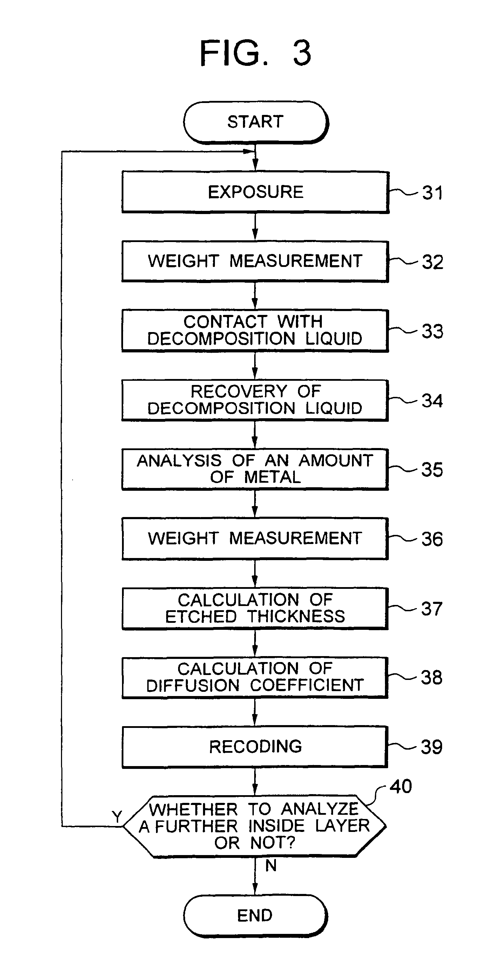

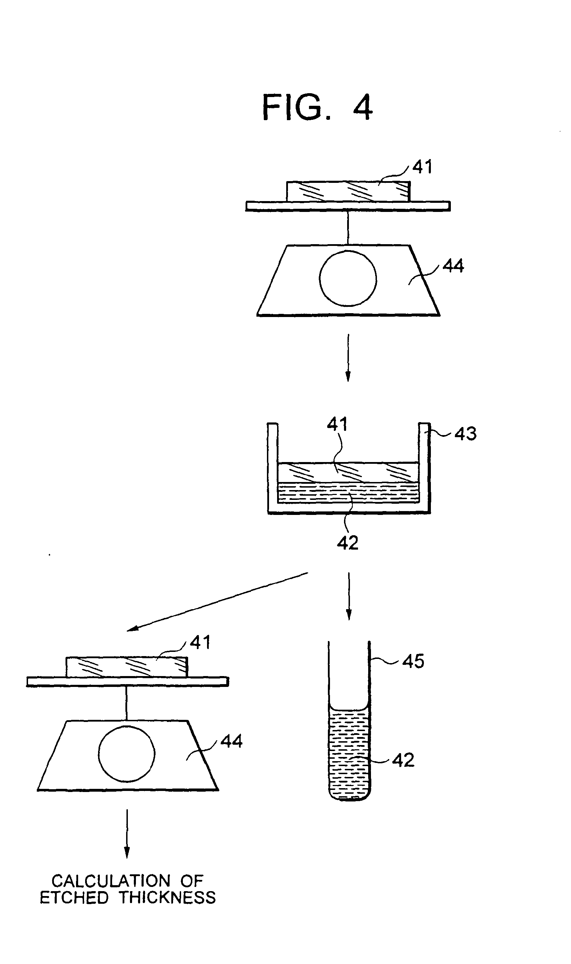

Fig. 3 is a flowchart showing another flow of an analysis method involving an embodiment different from one shown in Fig. 1, Fig. 4 being a diagram schematically showing the circumstances implementing the present method. In the present embodiment, a method for calculating a volume of a layer to be analyzed in the embodiment shown in Fig. 1 is altered to another one. In addition to the above, a contact between a layer to be analyzed and a decomposition liquid is implemented, not by dripping the decomposition liquid, but in a container therein the decomposition liquid is accommodated.

In implementing the analysis method involving the present embodiment, first for instance a rectangular or square specimen 41 is prepared, the specimen 41 being immersed in a surface treatment liquid, for instance hydrofluoric acid (HF), to etch a surface thereof 41. The etched surface is a surface of a layer to be analyzed. For instance, a surface of a layer at a depth of 10 µm from the surface of the specimen 41 is exposed (step 31). A thickness of the layer to be etched at this time can be controlled by appropriately adjusting the concentration of the treatment liquid such as hydrofluoric acid being used and conditions such as etching period and temperature. Hydrofluoric acid can be in any form of liquid and gaseous (vapor) forms. These are identical as the first embodiment.

Next, from in hydrofluoric acid the specimen 41 is taken out, being cleaned and dried, thereafter a weight of the specimen 41 is measured by means of a weighing device 44 (step 32). In measuring the weight, various kinds of known weighing methods may be used. Thus obtained weight is recorded as wn.

Next, the specimen 41 is put into a container 43 therein a decomposition liquid 42, for instance, a mixed liquid of hydrofluoric acid and nitric acid is contained, one surface of the specimen 41 being made to come into contact with the decomposition liquid (step 33). At this time, the decomposition liquid 42 may be hydrofluoric acid alone, or a mixed liquid of hydrofluoric acid and other acid, for instance one or more of nitric acid, hydrochloric acid and sulfuric acid, or a mixed liquid of hydrofluoric acid and hydrogen peroxide, or a mixed liquid of hydrofluoric acid and hydrogen peroxide and other acid for instance one or more of nitric acid, hydrochloric acid and sulfuric acid.

Considering an easiness with which metal atoms in quartz dissolve into the decomposition liquid 42, a mixed liquid of hydrofluoric acid and nitric acid can be preferably used.

Composition and concentration of the decomposition liquid 42 and mixing ratio in the mixed liquid are preferably adjusted to values appropriate for decomposing a surface of quartz of the specimen 41 by for instance 10 µm per approximately 30 min.

The decomposition liquid 42 and the specimen 41, after coming into contact, are maintained as they are at an appropriate temperature, the surface of the quartz specimen 41 being decomposed by a very thin layer, by a layer of a thickness of for instance approximately 10 µm.

Though the period and conditions when the decomposition liquid 42 is maintained are design matter, these are preferably adjusted so that the surface of the quartz is decomposed by for instance approximately 10 µm per approximately 30 min.

Next, upon completion of the decomposition after a prescribed period, the decomposition liquid 42 is recovered in a recovery container 45 (step 34).

Thus obtained decomposition liquid 42 is subjected to quantitative analysis equipment, thereby metal contained in the decomposition liquid 42, for instance a content of copper being analyzed (step 35). At that time, whatever analysis equipment may be used as the quantitative analysis equipment, typically for instance an atomic absorption spectroscopy (AAS), ICP-AES (Inductively Coupled Plasma Atomic Emission Spectroscopy), ICP-MS (Inductively Coupled Plasma Mass Spectroscopy) or the like may be used. An amount of metal obtained at this time is recorded as Cn.

Next, a weight of the quartz specimen 41 of which surface is decomposed in the aforementioned step 33 is measured in the manner identical with that in the step 32 (step 36). Thus obtained weight of the specimen 41 is recorded as wₙ₊₁.

Next, from thus obtained data, a metal concentration of the layer to be analyzed is calculated. That is, from the weights wn and wₙ₊₁ of the specimens 41 obtained respectively in the steps 32 and 36, a weight of the layer to be analyzed is obtained as a difference thereof. With thus obtained weight and a density of the specimen 41 measured in advance, a volume Vn of the layer to be analyzed is obtained. With thus obtained volume and an area S of a surface of the layer to be analyzed that is measured in advance, a thickness thereof also can be calculated (step 37). Thus obtained thickness is used to indicate a position in a depth direction of the layer to be analyzed in the specimen 41. In the volume Vn, the amount Cn obtained in the step 35 is contained. The metal concentration contained in the layer to be analyzed is given form Cn/Vn.

Given the concentrations of metal, a diffusion coefficient D of the layer to be analyzed can be obtained from Fick's second law ∂C/∂t = D · ∂²C/∂X², as ln C = - X²/4Dt + A. (In the equations, C: a concentration of metal at a depth X (atoms/cm³), D: a diffusion coefficient (cm²/s), X: depth (cm), t: diffusion time (sec), A: constant). By solving the above equation, the diffusion coefficient D can be obtained (step 38). The obtained diffusion coefficient is recorded as Dn (step 39).

Following this, whether a further inside layer is necessary to be analyzed quantitatively as a layer to be analyzed or not is judged (step 40). When judged that the further quantitative analysis is necessary, returning to the step 31, with hydrofluoric acid, similarly for the further inside layer too, the steps from 31 to 39 are repeated to obtain a diffusion coefficient Dₙ₊₁.

After that, the steps 31 through 40 are similarly repeated to analyze thin layers of a thickness of approximately 10 µm consecutively from the outside to the inside of the quartz specimen 41, the respective diffusion coefficients D₁, D₂, D₃, ---, Dₙ, Dₙ₊₁, Dₙ₊₂, --- Dₓ being obtained and recorded. Upon completion of the quantitative analysis of the innermost side of the layer to be analyzed, all the analysis operations are over.

Even in the second embodiment explained in the above, with hydrofluoric acid a surface of a layer to be analyzed at a desired depth is exposed, thereafter a content of metal in the layer to be analyzed being analyzed. Accordingly, a metal content at an arbitrary depth of the specimen 41, in its turn a diffusion coefficient in the arbitrary layer, can be analyzed.

Furthermore, with the decomposition liquid 42 a layer to be analyzed is decomposed to quantitatively analyze. Accordingly, a very thin layer can be analyzed.

The present invention is not restricted to the range disclosed in the aforementioned embodiments and embodiments. In the aforementioned embodiments and embodiments, the case of analyzing the concentration and diffusion coefficient of for instance copper contained in the quartz is explained as the example. However, the present invention can be similarly applied to metals other than copper.

Furthermore, in the aforementioned embodiments, the quartz specimens 21 and 41 are divided into multi-layers to be analyzed inwardly from the outside thereof, the layers to be analyzed each being successively quantitatively analyzed. However, the layer to be quantitatively analyzed may be one layer, or all analyzable layers of the quartz specimen 21 and 41 may be quantitatively analyzed from the outermost portion thereof, or only some layers to be analyzed at particular depths may be quantitatively analyzed.

### (Third Embodiment)

Next, a third embodiment of the present invention will be explained. In embodiments following the present embodiment, the contents duplicating with that of the preceding embodiments will be omitted from explanation.

In the present embodiment, quartz material having, in a depth direction, 200 µm or more of a metal diffusion region of which diffusion coefficient obtained by the use of the analysis methods explained in the aforementioned first or second embodiments is 5.8 E-10cm²/s or less is used to manufacture a quartz tube.

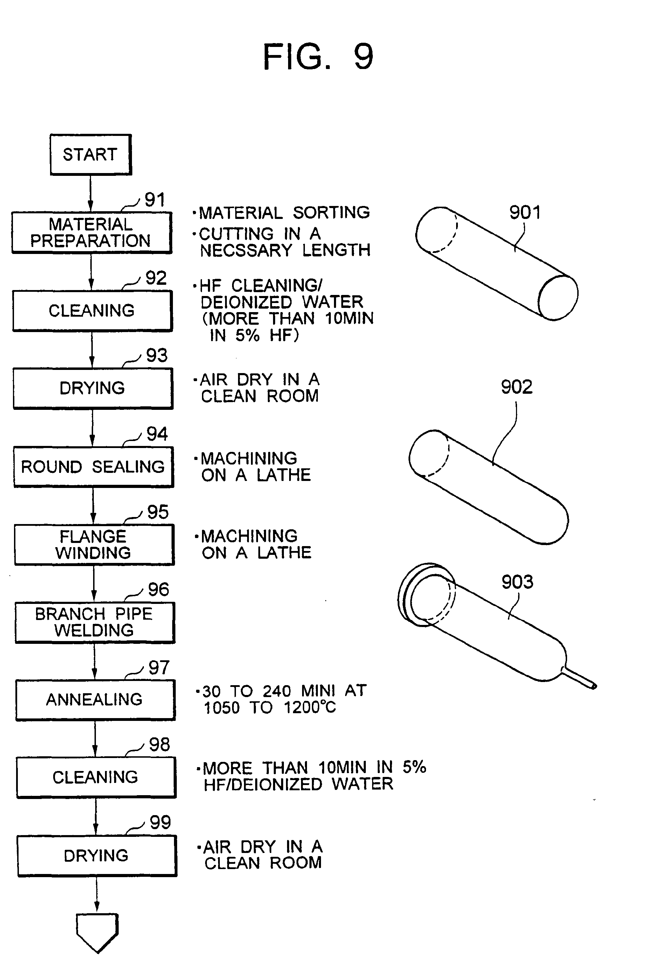

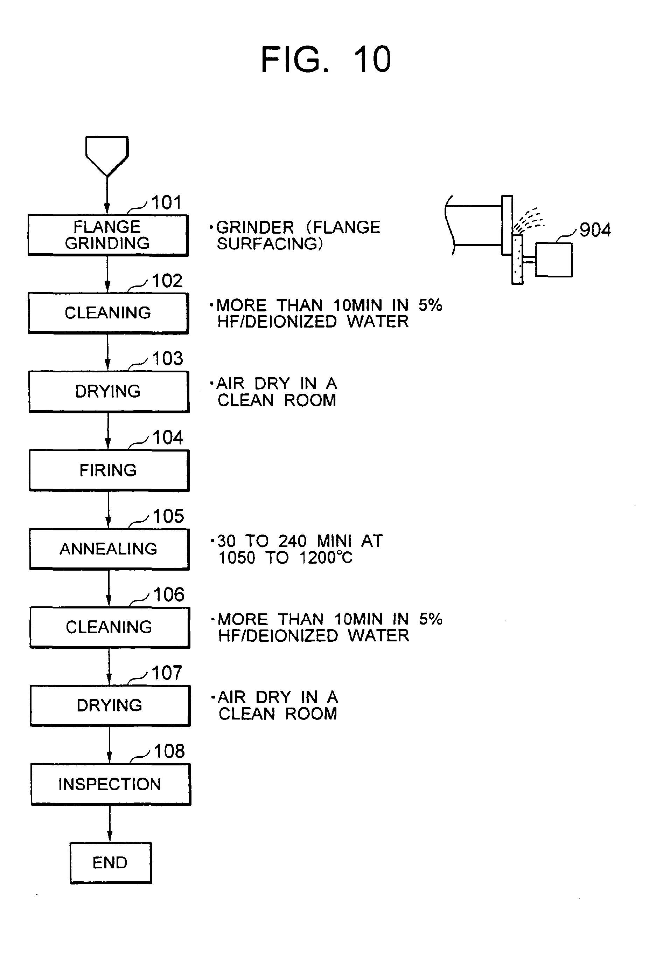

Figs. 9 and 10 are flowcharts showing a flow of manufacturing steps of a quartz tube involving the present embodiment.

In implementing a manufacturing method of a quartz tube involving the present embodiment, first of all quartz material is sorted out (step 91). At that time, a criterion for sorting out the quartz material is whether or not the material has 200 µm or more, in a depth direction, of a metal diffusion region of which diffusion coefficient is 5.8 E-10 cm²/s or less.

Here, a reason for sorting out one of which diffusion coefficient is in the aforementioned range is that when the diffusion coefficient is outside the range, metal atoms diffuse through the quartz in a short time to copy on wafers being treated. Thus, an inconvenience that causes an occurrence of poor quality due to so-called contamination is invited.

As another index, other than the diffusion coefficient, for judging quality of quartz material, a content of hydroxy group can be cited. In specific, the quartz material of which content of hydroxy group is 60 µg/g or less is preferably used.

Here, a reason for restricting a preferable range of the hydroxy group content to the aforementioned one is as follows. When the content of the hydroxy group is outside of the aforementioned range, a region of which diffusion coefficient of metal in the quartz material is 5.8 E-10 cm²/s or less can not satisfy the depth of 200 µm. As a result, the metal atoms diffuse through the quartz in a short time to copy on wafers being treated, causing as so-called contamination an inconvenience of an occurrence of poor quality.

This is because there are considered the following relationship between the number of hydroxy group in the quartz material and the diffusion coefficient thereof. That is, when the number of the hydroxy group increases, the diffusion coefficient also increases, in other words, a region of small diffusion coefficient in a depth direction becomes shallower.

As the support thereof, the followings are found from Fig. 8. That is, in the quartz manufactured due to the electric melting process in which metal atoms are confirmed to diffuse with relative difficulty, an amount of hydroxy group is lower. On the other hand, in the quartz manufactured due to flame fusion method in which metal atoms are confirmed to diffuse with relative easiness, the amount of hydroxy group is higher.

Accordingly, when compared with the quartz material manufactured due to the flame fusion method, it is preferable to manufacture a quartz tube with the quartz material manufactured due to the electric melting process.

Furthermore, as still another index other than the diffusion coefficient, a density of the quartz material can be cited. In specific, it is preferable to use the quartz material of which density is in the range of 2.2016 g/cm³ to 2.2027 g/cm³.

Here, the reason for restricting the preferable value of the density in the aforementioned range is as follows. That is, when the density deviates out of the aforementioned range, a region of which diffusion coefficient of metal in the quartz material is 5.8E-10 cm²/s or less does not reach a depth of 200 µm. As a result, the metal atoms diffuse through the quartz in a short time to be copied on wafers being treated. Thus, so called contamination is caused to result in an inconvenience of an occurrence of poor quality.

The relationship between the density of the quartz material and the diffusion coefficient therein is considered as follows. That is, when the density deviates out of the aforementioned range, the diffusion coefficient becomes larger, in other words, a region in a depth direction of which diffusion coefficient is small becomes shallower.

Furthermore, as still another index other than the diffusion coefficient, a copper content in the quartz material can be cited. In specific, it is preferable to use the quartz material of which copper content is 5 ng/g or less.

Here, the reason for restricting the preferable copper content in the aforementioned range is as follows. That is, when the copper content deviates out of the aforementioned range, a region of which diffusion coefficient of metal in the quartz material is 5.8E-10 cm²/s or less does not reach a depth of 200 µm. As a result, the metal atoms diffuse through the quartz in a short time to be copied on wafers being treated. Thus, so called contamination is caused to result in an inconvenience of an occurrence of poor quality.

This is because the relationship between the copper content in the quartz material and the diffusion coefficient thereof is considered as follows. That is, when the copper content increases, the diffusion coefficient becomes larger, in other words, a region in a depth direction of which diffusion coefficient is small becomes shallower.

The quartz material thus sorted out, after cutting in a length necessary for manufacturing a quartz tube shown in an outline shape 901, is cleaned (step 92). The cleaning is performed, before the following machining, of all material including quartz material with hydrofluoric acid and deionized water. For instance, with 5 % hydrofluoric acid the cleaning is carried out for more than 10 min, followed by cleaning with deionized water.

Next, it is air dried in a clean room (step 93), followed by, while shaping one end side on a lathe in a hemisphere like an outline shape 902, closing to seal round (step 94). Similarly, while rotating on the lathe, an open end side is spread outwardly in a diameter direction to shape a flange (step 95).

Furthermore, a branch pipe for feeding a gas into the quartz tube is welded to shape like an outline shape 903. Then, by annealing, strain caused during the welding is relieved (step 97). The annealing is carried out for instance at a temperature between 1050 to 1200 °C for 30 to 240 min.

Next, when cleaned with hydrofluoric acid, the cleaning with deionized water is followed (step 98). The cleaning, for instance, after cleaning with 5 % hydrofluoric acid for more than 10 min, is performed by the use of deionized water. Then, for instance in a clean room, it is air dried (step 99).

Next, a flange portion shaped in the step 95 is ground by the use of a grinder 904 (step 101), followed by cleaning (step 102). The cleaning, for instance, after cleaning with 5% hydrofluoric acid for more than 10 min, is performed by the use of deionized water. Then, for instance in a clean room, it is air dried (step 103).

Then, the obtained quartz tube is fired by means of a burner to carry out firing (step 104). A firing temperature at this time is cited as still another index other than the diffusion coefficient. In concrete, the firing temperature is preferable to be in the range of 1050 to 1500 °C.

Here, the reason for restricting the preferable firing temperature in the aforementioned range is as follows. That is, when the firing temperature deviates out of the aforementioned range, a region of which diffusion coefficient of metal in the quartz material is 5.8E-10 cm²/s or less does not reach a depth of 200 µm. As a result, the metal atoms diffuse through the quartz in a short time to be copied on wafers being treated. Thus, so called contamination is caused to result in an inconvenience of an occurrence of poor quality.

This is because the relationship between the firing temperature and the diffusion coefficient of the quartz material is considered as follows. That is, when the firing temperature deviates outside of the aforementioned range, the diffusion coefficient becomes larger, in other words, a region in a depth direction of which diffusion coefficient is small becomes shallower.

Next, by annealing again, strain is relieved (step 105). The annealing is implemented for instance at a temperature in the range of 1050 to 1200 °C for 30 to 240 min.

Next, when cleaned by hydrofluoric acid, the cleaning with deionized water is followed (step 106). The cleaning, for instance, after cleaning with 5 % hydrofluoric acid for more than 10 min, is performed by the use of deionized water. Then, for instance in a clean room, it is air dried (step 107).

Thus manufactured quartz tube is further inspected (step 108) to be finally a completed product.

According to a manufacturing method of the present embodiment, in a stage of material sorting, by the use of the analysis method shown in the first or second embodiments an accurate diffusion coefficient can be obtained. Owing to thus obtained diffusion coefficient, quartz material furnished with adequate physical properties can be sorted out, a quartz tube being manufactured by the use of the sorted quartz material. Accordingly, quartz tubes that can be heat-treated without causing the contamination due to metal atoms can be manufactured.

### (Fourth Embodiment)

In the following, a fourth embodiment of the present invention will be explained with reference to the drawings.

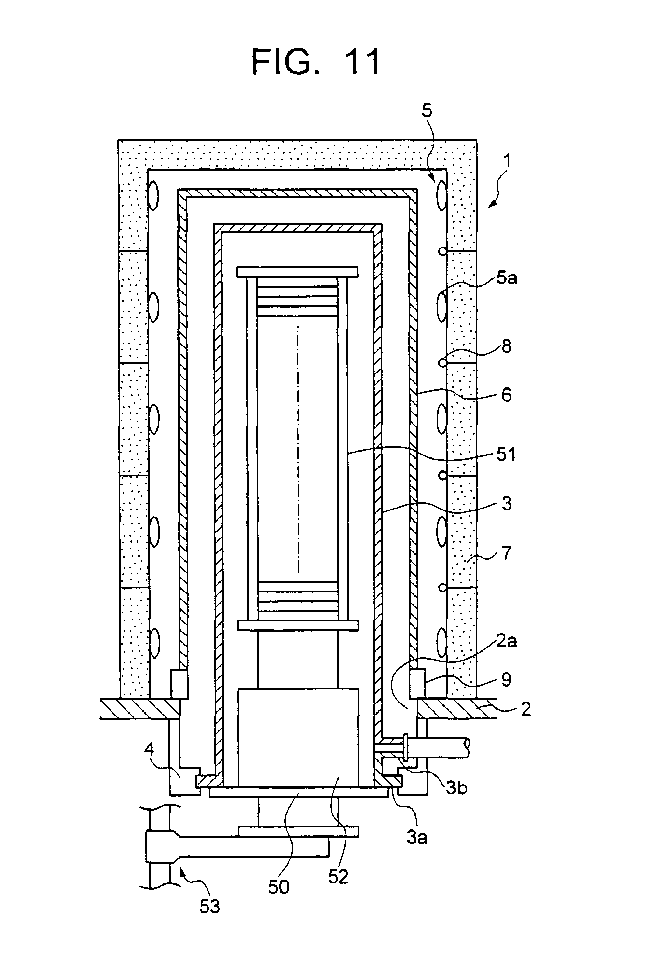

Fig. 11 is a diagram showing an entire configuration of thermal treatment equipment. In Fig. 11, reference numeral 1 denotes a vertical treatment furnace for treating semiconductor wafers, objects to be treated, under a high temperature, the treatment furnace 1 comprising a level base plate 2 having a circular opening 2a in the central portion thereof. In the opening 2a of the base plate 2, a quartz tube 3 is inserted through as a cylindrical treatment tube that is open at a lower end and has a flange portion 3a at the open end. A periphery portion of the flange portion 3a of the quartz tube 3 is removably attached to the base plate 2 through a manifold 4. In addition, at a lower side portion of the quartz tube 3, an inlet tube portion 3b for introducing a treatment gas and an exhaust tube portion not shown in the figure for exhausting the treatment gas are formed in one body.

At the periphery portion of the quartz tube 3, a heater 5 for heating the inside of the quartz tube 3 is disposed. Between the heater 5 and the quartz tube 3, an equalizing tube 6 is disposed concentrically with the quartz tube 3 so as to cover the quartz tube 3 to equalize the heating due to the heater 5. A heat generating resistance wire 5a consisting of alloy of iron (Fe), chromium (Cr) and aluminum (Al) is wound in coil to form the heater 5. Outside and above thereof, an insulator 7 is disposed to cover it, the outside of the insulator 7 being covered by an outer shell not shown in the figure. As the heat generating resistance wire 5a, one consisting of molybdenum disilicide (MoSi₂) or kanthal (trade name) is also applicable.

The heater 5 is divided into a plurality (for instance 3 to 5) of zones in a height direction, to the respective zones temperature sensors 8 being disposed to enable to independently temperature-control the respective zones. The heater 5, the insulator 7 and the outer shell are supported on the base plate 2. The equalizing tube 6 is formed of thermal resistant material, for instance silicon carbide (SiC), to have a cylindrical shape opened at a lower end, the lower end portion thereof being supported on the base plate 2 through an annular insulating support 9.

Downward of the quartz tube 3, a closing plate 50 for opening/closing a lower end opening thereof is disposed. On the closing plate 50, a wafer boat 51 for holding many pieces of semiconductor wafers level in multiple steps spaced in a vertical direction is disposed through a heat insulating mould 52. The closing plate 50 takes the wafer boat 51 into and out of the quartz tube 3, being connected to an elevator 53 for opening/closing the closing plate 50.

Next, an operation of thus configured heat treatment apparatus will be explained. The inside of the quartz tube 3 of the treatment furnace 1 is heated in advance by the heater 5 to a prescribed temperature, being gas purged by nitrogen gas. In this state, the closing plate 50 is opened, the wafer boat 51 holding the semiconductor wafers being introduced into the quartz tube 3 together with the heat insulating mould 52 due to an ascending movement of the closing plate 50. The treatment gas is introduced through the gas inlet tube portion 3b to start treating.

In the treatment, the temperature sensor 8 controls the heater 5 to be a temperature necessary for the treatment.

The heater 5, when electricity is turned on to start heating, is heated to a high temperature, metal atoms such as copper contained in the heater 5 flying out of the heater 5 to stick on a surface of the quartz tube 3.

However, the quartz tube 3 is formed of material of which diffusion coefficient is confirmed to be sufficiently small by the use of the analysis method detailed in the first or second embodiments. As a result, the metal atoms including copper stuck on the surface of the quartz tube 3 can not easily diffuse inside the quartz tube 3, the number of the metal atoms capable of diffusing to reach the interior surface of the quartz tube 3 being almost zero. Accordingly, even during heat treatment, the inside of the quartz tube 3 can be maintained in an extremely clean state. That is, the problem of contamination that is caused by sticking of the metal atoms including copper on wafers being heat treated can be prevented in advance.

The present invention, without restricting to the aforementioned embodiments, can be modified in various modes within the scope of the present invention to implement. For instance, in the aforementioned embodiments, though the vertical heat treatment furnace 1 is illustrated, a horizontal treatment furnace also can be applicable. Furthermore, as the object to be treated, other than the semiconductor wafers, for instance LCDs can be treated.

According to the present invention, by the use of an analysis method of high accuracy, a diffusion coefficient of high reliability can be obtained. Furthermore, by obtaining the diffusion coefficient of high reliability by the use of the analysis method of high accuracy, quality of quartz material is sorted out. Accordingly, quartz member used for semiconductor manufacturing equipment such as a quartz tube in which metal atoms diffuse with difficulty can be obtained. Industrial Applicability

Quartz member involving the present invention can be manufactured in a materials industry such as a glass-making industry or the like. The manufactured quartz member can be used as components for semiconductor manufacturing equipment. Accordingly, it can be used in a manufacturing industry of the semiconductor manufacturing equipment.

A manufacturing method of the quartz member involving the present invention can be used in a material industry such as glass manufacture or the like. The quartz member manufactured according to the manufacturing method can be used as components for semiconductor manufacturing equipment. Accordingly, it can be used in a manufacturing industry of the semiconductor manufacturing equipment.

Furthermore, the thermal treatment equipment involving the present invention can be manufactured in a manufacturing industry of the semiconductor manufacturing equipment. The manufactured thermal treatment equipment can be used in a semiconductor manufacturing industry.

Furthermore, an analysis method involving the present invention can be used in a material industry such as glass manufacture or the like.

## Claims

1. A quartz member for semiconductor manufacturing equipment formed of quartz material,
wherein the quartz material comprises a metal diffusion region of a depth of 200 µm or more of which the copper diffusion coefficient D is 5.8E-10 cm²/s or less,
wherein the copper diffusion coefficient is obtained by the use of an analysis method of copper in the quartz material, the analysis method comprising:
- a first step of exposing a layer to be analized at a desired depth in a quartz specimen;
- a second step of chemically decomposing the layer to be analized to separate a decomposition product from the quartz specimen;
- a third step of analizing an amount of copper in the separated decomposition product; and
- a fourth step of obtaining a volume of the layer to be analized from a volume change between the quartz specimens before decomposition of the layer to be analized and after separation of the decomposition therefrom.

2. The quartz member for semiconductor manufacturing equipment as set forth in claim 1,
wherein in the fourth step of obtaining the volume of the layer to be analized in the analysis method, the volume of the layer to be analized is calculated from a thickness change between the quartz specimens before the decomposition of the layer to be analized and after the separation of the decomposition product therefrom to obtain.

3. The quartz member for semiconductor manufacturing equipment as set forth in claim 1,
wherein in the fourth step of obtaining the volume of the layer to be analized in the analysis method, the volume of the layer to be analized is calculated from a weight change between the quartz specimens before the decomposition of the layer to be analized and after the separation of the decomposition product therefrom to obtain.

4. The quartz member for semiconductor manufacturing equipment as set forth in one of the preceding claims,
wherein the analysis method further comprises
- a fifth step of exposing a new a layer to be analized located furthermore inside in a depth direction than the analized layer; and
- a sixth step of repeating the second through fifth steps to obtain a concentration distribution of metal diffused in a thickness direction of the quartz specimen.

5. The quartz member for semiconductor manufacturing equipment as set forth in any of claims 1 to 4,
wherein the first and/or fifth step of exposing the layer to be analized in the analysis method is a step of etching a surface of the quartz specimen with hydrofluoric acid.

6. The quartz member for semiconductor manufacturing equipment as set forth in any of claims 1 to 5,
wherein the second step of chemically decomposing the layer to be analized to separate a decomposition product from the quartz specimen in the analysis method comprises the steps of:
- dripping a-decomposition liquid on a surface of the exposed layer to be analized;
- keeping the dripped decomposition liquid in contact with the exposed layer to be analized for a prescribed period to decompose; and
- recovering the decomposition liquid in which the layer to be analized is decomposed and contained.

7. The quartz member for semiconductor manufacturing equipment as set forth in any of claims 1 to 6,
wherein the decomposition liquid is hydrofluoric acid alone, or a mixed liquid of hydrofluoric acid and at least one or more selected from a group of nitric acid, hydrochloric acid, sulfuric acid, and hydrogen peroxide.

8. The quartz member for semiconductor manufacturing equipment as set forth in any of claims 1 to 7,
wherein the third step of analizing an amount of copper in the separated decomposition liquid in the analysis method is carried out by the use of atomic absorption spectroscopy, inductively coupled plasma atomic emission spectroscopy, or inductively coupled plasma mass spectroscopy.

9. The quartz member for semiconductor manufacturing equipment as set forth in any of claims 1 to 8,
wherein the quartz member contains 60 µg/g or less of hydroxy group.

10. The quartz member for semiconductor manufacturing equipment as set forth in any of claims 1 to 9,
wherein the quartz member has been heat treated at a temperature in the range of 1050 to 1500° C.

11. The quartz member for semiconductor manufacturing equipment as set forth in any of claims 1 to 10,
wherein the quartz member has a density in the range of 2.2016 to 2.2027 g/cm³.

12. The quartz member for semiconductor manufacturing equipment as set forth in any of claims 1 to 11,
wherein the quartz member contains 5 ng/g or less of copper.

13. The quartz member for semiconductor manufacturing equipment as set forth in any of claims 1 to 12,
wherein the quartz member has been formed by the use of an electric melting process.

14. The quartz member for semiconductor manufacturing equipment as set forth in any of claims 1 to 13,
wherein the quartz member is used for a quartz glass furnace tube.

15. A manufacturing method to make a quartz member for semiconductor manufacturing equipment, comprising the steps of:
forming quartz material so as to comprise 200 µm or more of a metal diffusion region of which the copper diffusion coefficient D is 5.8E-10 cm²/s or less; and
molding the formed quartz material in tube,
wherein the copper diffusion coefficient is obtained by the use of an analysis method of metal in the quartz material, the analysis method comprising:
- a first step of exposing a layer to be analized at a desired depth in a quartz specimen;
- a second step of chemically decomposing the layer to be analized to separate a decomposition product from the quartz specimen;
- a third step of analizing an amount of copper in the separated decomposition product;
- a fourth step of obtaining a volume of the layer to be analized from a volume change between the quartz specimens before the decomposition of the layer to be analized and after the separation of the decomposition product therefrom.

16. The manufacturing method of claim 15, wherein the analysis method further comprises:
- a fifth step of exposing anew a layer to be analized located furthermore inside in a depth direction than the analized layer; and
- a sixth step of repeating the second through fifth steps to obtain a concentration distribution of copper diffused in a thickness direction of the quartz specimen.

17. Thermal treatment equipment, comprising:
a body defining a cylindrical heat treatment space extending in an up and down direction;
a quartz tube accommodating a substrate to be treated disposed in the heat treatment space, being formed of quartz material having 200 µm or more of a metal diffusion region of which the copper diffusion coefficient D is 5.8E-10 cm²/s or less;
a heater for heating an exterior surface of the quartz tube;
a gas feed unit for feeding a gas into the quartz tube; and
means for holding removably in the quartz tube a plurality of substrates to be treated in a mutually level state,
wherein the copper diffusion coefficient is obtained by the use of an analysis method of metal in quartz material, the analysis method comprising:
- a first step of exposing a layer to be analized at a desired depth in a quartz specimen;
- a second step of chemically decomposing the layer to be analized to separate a decomposition product from the quartz specimen;
- a third step of analizing an amount of metal in the separated decomposition product;
- a fourth step of obtaining a volume of the layer to be analized from a volume change between the quartz specimens before decomposition of the layer to be analized and after separation of the decomposition product therefrom.

18. The thermal treatment equipment of claim 17, wherein the analysis method further comprises:
- a fifth step of exposing anew a layer to be analized located furthermore inside in a depth direction than the analized layer; and
- a sixth step of repeating the second through fifth steps to obtain a concentration distribution of copper diffused in a thickness direction of the quartz specimen.

19. An analysis method for obtaining a diffusion coefficient of copper in quartz member, comprising:
- a first step of exposing a layer to be analized at a desired depth in a quartz specimen;
- a second step of chemically decomposing the layer to be analized to separate a decomposition product from the quartz specimen;
- a third step of analizing an amount of copper in the separated decomposition product; and
- a fourth step of obtaining a volume of the layer to be analized from a volume change between the quartz specimens before decomposition of the layer to be analized and after separation of the decomposition product therefrom.

20. The analysis method of claim 19, further comprising:
- a fifth step of exposing anew a layer to be analized located furthermore inside in a depth direction than the analized layer; and
- a sixth step of repeating the second through fifth steps to obtain a concentration distribution of copper diffused in a thickness direction of the quartz specimen.

21. The analysis method as set forth in claim 19 or 20,
wherein in the step of obtaining a volume of the layer to be analized, a volume of the layer to be analized is calculated from a change in thickness of the quartz specimens before decomposition of the layer to be analized and after separation of the decomposition product therefrom.

22. The analysis method as set forth in claim 19 or 20,
wherein in the step of obtaining a volume of the layer to be analized, a volume of the layer to be analized is calculated from a change in weight of the quartz specimens before decomposition of the layer to be analized and after separation of the decomposition product therefrom.

23. The analysis method as set forth in claim 19 or 20,
wherein the first and/or fifth step of exposing the layer to be analized is a step of etching a surface of the quartz specimen with hydrofluoric acid.

24. The analysis method as set forth in claim 19,
wherein the second step of chemically decomposing the layer to be analized to separate a decomposition product from the quartz specimen comprises the steps of:
- dripping a decomposition liquid on a surface of the exposed layer to be analized;
- keeping the dripped decomposition liquid in contact with the exposed layer to be analized for a prescribed period to decompose; and
- recovering the decomposition liquid in which the layer to be analized is decomposed and contained.

25. The analysis method as set forth in claim 24,
wherein the decomposition liquid is hydrofluoric acid alone, or a mixed liquid of hydrofluoric acid and at least one or more selected from a group of nitric acid, hydrochloric acid, sulfuric acid, and hydrogen peroxide.

26. The analysis method as set forth in claim 19,
wherein the third step of analizing an amount of copper in the separated decomposition product is carried out by the use of atomic absorption spectroscopy, inductively coupled plasma atomic emission spectroscopy, or inductively coupled plasma mass spectroscopy.

## Patentansprüche

1. Quarzelement für Halbleiterherstellungsanlage, welches aus Quarzmaterial gebildet ist,
wobei das Quarzmaterial eine Metalldiffusionsregion von einer Tiefe von 200 µm oder mehr umfaßt, deren Kupferdiffusionskoeffizient D 5,8 x 10⁻¹⁰ cm²/s oder weniger ist,
wobei der Kupferdiffusionskoeffizient durch das Verwenden eines Analyseverfahrens des Kupfers in dem Quarzmaterial erhalten wird, wobei das Analyseverfahren umfaßt:
- einen ersten Schritt des Freilegens einer zu analysierenden Schicht in einer gewünschten Tiefe in einem Quarzprobestück;
- einen zweiten Schritt des chemischen Zersetzens der zu analysierenden Schicht, um ein Zersetzungsprodukt von dem Quarzprobestück zu trennen;
- einen dritten Schritt des Analysierens einer Kupfermenge in dem abgetrennten Zersetzungsprodukt; und
- einen vierten Schritt des Ermittelns eines Volumens der zu analysierenden Schicht aus einer Volumenänderung zwischen dem Quarzprobestück vor dem Zersetzen der zu analysierenden Schicht und nach Abtrennen des Zersetzungsprodukts.

2. Quarzelement für Halbleiterherstellungsanlage nach Anspruch 1,
wobei in dem vierten Schritt des Ermittelns des Volumens der zu analysierenden Schicht in dem Analyseverfahren das Volumen der zu analysierenden Schicht aus einer Dickenänderung zwischen dem Quarzprobestück vor dem Zersetzen der zu analysierenden Schicht und nach dem Abtrennen des zu erhaltenden Zersetzungsprodukts berechnet wird.

3. Quarzelement für Halbleiterherstellungsanlage nach Anspruch 1,
wobei in dem vierten Schritt des Ermittelns der zu analysierenden Schicht in dem Analyseverfahren das Volumen der zu analysierenden Schicht aus einer Gewichtsänderung zwischen dem Quarzprobestück vor dem Zersetzen der zu analysierenden Schicht und nach dem Abtrennen des zu erhaltenden Zersetzungsproduktes berechnet wird.

4. Quarzelement für Halbleiterherstellungsanlage nach einem der vorhergehenden Ansprüche,
wobei das Analyseverfahren des weiteren umfaßt:
- einen fünften Schritt des Freilegens einer neuen zu analysierenden Schicht, welche in einer Tiefenrichtung weiter im Inneren als die analysierte Schicht liegt; und
- einen sechsten Schritt des Wiederholens des zweiten bis fünften Schrittes, um eine Konzentrationsverteilung von diffundiertem Metall in einer Dickenrichtung des Quarzprobestücks zu erhalten.

5. Quarzelement für Halbleiterherstellungsanlage nach einem der Ansprüche 1 bis 4,
wobei der erste und/oder fünfte Schritt des Freilegens der zu analysierenden Schicht in dem Analyseverfahren ein Schritt des Ätzens einer Oberfläche des Quarzprobestücks mit Flußsäure ist.

6. Quarzelement für Halbleiterherstellungsanlage nach einem der Ansprüche 1 bis 5,
wobei der zweite Schritt des chemischen Zersetzens der zu analysierenden Schicht, um ein Zersetzungsprodukt von dem Quarzprobestück abzutrennen, in dem Analyseverfahren die folgenden Schritte umfaßt:
- Träufeln einer Zersetzungsflüssigkeit auf eine Oberfläche der freigelegten zu analysierenden Schicht;
- Halten der aufgeträufelten Zersetzungsflüssigkeit in Kontakt mit der freigelegten zu analysierenden Schicht für eine vorgeschriebene Zeitdauer zum Zersetzen; und
- Rückgewinnen der Zersetzungsflüssigkeit, in welcher die zu analysierende Schicht zersetzt und enthalten ist.

7. Quarzelement für Halbleiterherstellungsanlage nach einem der Ansprüche 1 bis 6,
wobei die Zersetzungsflüssigkeit nur Flußsäure oder eine gemischte Flüssigkeit aus Flußsäure und wenigstens einem Stoff der Gruppe Salpetersäure, Salzsäure, Schwefelsäure und Wasserstoffperoxid ist.

8. Quarzelement für Halbleiterherstellungsanlage nach einem der Ansprüche 1 bis 7,
wobei der dritte Schritt des Analysierens einer Kupfermenge in der abgetrennten Zersetzungsflüssigkeit in dem Analyseverfahren mit Hilfe der Atom-Absorptionsspektroskopie, induktiv gekoppelter Plasma-Atomemissionsspektroskopie oder induktiv gekoppelter Plasma-Massenspektroskopie durchgeführt wird.

9. Quarzelement für Halbleiterherstellungsanlage nach einem der Ansprüche 1 bis 8, wobei das Quarzelement 60 µg/g oder weniger der Hydroxygruppe umfaßt.

10. Quarzelement für Halbleiterherstellungsanlage nach einem der Ansprüche 1 bis 9, das bei einer Temperatur im Bereich von 1050 bis 1500°C wärmebehandelt ist.

11. Quarzelement für Halbleiterherstellungsanlage nach einem der Ansprüche 1 bis 10, das eine Dichte im Bereich von 2,2016 bis 2,2027 g/cm³ aufweist.

12. Quarzelement für Halbleiterherstellungsanlage nach einem der Ansprüche 1 bis 11, das 5 ng/g oder weniger an Kupfer umfaßt.

13. Quarzelement für Halbleiterherstellungsanlage nach einem der Ansprüche 1 bis 12, das mit Hilfe eines elektrischen Schmelzprozesses gebildet worden ist.

14. Quarzelement für Halbleiterherstellungsanlage nach einem der Ansprüche 1 bis 13, das für eine Quarzglasofenröhre verwendet wird.

15. Verfahren zum Herstellen eines Quarzelements für eine Halbleiterherstellungsanlage, welches die Schritte umfaßt:
Bilden eines Quarzmaterials, das 200 µm oder mehr einer Metalldiffusionsregion umfaßt, deren Kupferdiffusionskoeffizient D 5,8 x 10⁻¹⁰ cm²/s oder weniger beträgt; und
Formen des gebildeten Quarzmaterials zu einer Röhre,
wobei der Kupferdiffusionskoeffizient mit Hilfe eines Analyseverfahrens des Metalls in dem Quarzmaterial erhalten wird, wobei das Analyseverfahren umfaßt:
- einen ersten Schritt des Freilegens einer zu analysierenden Schicht in einer bestimmten Tiefe in einem Quarzprobestück;
- einen zweiten Schritt eines chemischen Zersetzens der zu analysierenden Schicht, um ein Zersetzungsprodukt von dem Quarzprobestück zu trennen;
- einen dritten Schritt des Analysierens einer Kupfermenge in dem abgetrennten Zersetzungsprodukt;
- einen vierten Schritt des Erhaltens eines Volumens der zu analysierenden Schicht aus einer Volumensänderung zwischen dem Quarzprobestück vor dem Zersetzen der zu analysierenden Schicht und nach dem Abtrennen des Zersetzungsproduktes.

16. Herstellungsverfahren nach Anspruch 15, wobei das Analyseverfahren ferner umfaßt:
- einen fünften Schritt des erneuten Freilegens einer zu analysierenden Schicht, welche in einer Tiefenrichtung weiter im Inneren als die analysierte Schicht liegt; und
- einen sechsten Schritt des Wiederholens des zweiten bis fünften Schrittes, um eine Konzentrationsverteilung von diffundiertem Kupfer in einer Dickenrichtung des Quarzprobestücks zu erhalten.

17. Wärmebehandlungsanlage, welche umfaßt:
einen Körper, welcher einen zylindrischen Wärmebehandlungsraum definiert, welcher sich in einer Aufwärts- und Abwärtsrichtung erstreckt;
eine in dem Wärmebehandlungsraum angeordnete Quarzröhre, welche ein zu behandelndes Substrat aufnimmt, welche aus einem Quarzmaterial gebildet ist, das 200 µm oder mehr einer Metalldiffusionsregion aufweist, deren Kupferdiffusionskoeffizient D 5,8 x 10⁻¹⁰ cm²/s oder weniger ist;
ein Heizelement zum Erhitzen einer äußeren Oberfläche der Quarzröhre;
eine Gaszuführeinheit zum Zuführen eines Gases in die Quarzröhre; und
eine Einrichtung zum herausnehmbaren Halten mehrerer zu behandelnder Substrate in einem zueinander horizontalen Zustand,
wobei der Kupferdiffusionskoeffizient mit Hilfe eines Analyseverfahrens des Metalls in dem Quarzmaterial erhalten wird, wobei das Analyseverfahren umfaßt:
- einen ersten Schritt des Freilegens einer zu analysierenden Schicht in einer gewünschten Tiefe in einem Quarzprobestück;
- einen zweiten Schritt des chemischen Zersetzens der zu analysierenden Schicht, um ein Zersetzungsprodukt von dem Quarzprobestück abzutrennen;
- einen dritten Schritt des Analysierens einer Metallmenge in dem abgetrennten Zersetzungsprodukt;
- einen vierten Schritt des Erhaltens eines Volumens der zu analysierenden Schicht aus einer Volumensänderung zwischen dem Quarzprobestück vor dem Zersetzen der zu analysierenden Schicht und nach dem Abtrennen des Zersetzungsprodukts davon.

18. Wärmebehandlungsanlage nach Anspruch 17, wobei das Analyseverfahren ferner umfaßt:
- einen fünften Schritt des erneuten Freilegens einer zu analysierenden Schicht, welche in einer Tiefenrichtung weiter im Inneren als die analysierte Schicht liegt; und
- einen sechsten Schritt des Wiederholens des zweiten bis fünften Schrittes, um eine Konzentrationsverteilung von diffundiertem Kupfer in einer Dickenrichtung des Quarzprobestücks zu erhalten.

19. Analyseverfahren zum Erhalten eines Diffusionskoeffizienten von Kupfer in einem Quarzprobestück, welches umfaßt:
- einen ersten Schritt des Freilegens einer zu analysierenden Schicht in einer gewünschten Tiefe in einem Quarzprobestück;
- einen zweiten Schritt des chemischen Zersetzens der zu analysierenden Schicht, um ein Zersetzungsprodukt von dem Quarzprobestück abzutrennen;
- einen dritten Schritt des Analysierens einer Kupfermenge in dem abgetrennten Zersetzungsprodukt; und
- einen vierten Schritt des Erhaltens eines Volumens der zu analysierenden Schicht aus einer Volumenänderung zwischen dem Quarzprobestück vor dem Zersetzen der zu analysierenden Schicht und nach dem Abtrennen des Zersetzungsproduktes.

20. Analyseverfahren nach Anspruch 19, welches ferner umfaßt:
- einen fünften Schritt des erneuten Freilegens einer zu analysierenden Schicht, welche in einer Tiefenrichtung weiter im Inneren als die analysierte Schicht liegt; und
- einen sechsten Schritt des Wiederholens des zweiten bis fünften Schrittes, um eine Konzentrationsverteilung von diffundiertem Kupfer in einer Dickenrichtung des Quarzprobestückes zu erhalten.

21. Analyseverfahren nach Anspruch 19 oder 20,
wobei bei dem Schritt des Erhaltens eines Volumens der zu analysierenden Schicht ein Volumen der zu analysierenden Schicht aus einer Dickenänderung des Quarzprobestückes vor Zersetzen der zu analysierenden Schicht und nach Abtrennen des Zersetzungsproduktes davon berechnet wird.

22. Analyseverfahren nach Anspruch 19 oder 20,
wobei in dem Schritt des Erhaltens eines Volumens der zu analysierenden Schicht ein Volumen der zu analysierenden Schicht aus einer Gewichtsveränderung des Quarzprobestücks vor Zersetzen der zu analysierenden Schicht und nach Abtrennen des Zersetzungsprodukts davon berechnet wird.

23. Analyseverfahren nach Anspruch 19 oder 20,
wobei der erste und/oder fünfte Schritt des Freilegens der zu analysierenden Schicht ein Schritt des Ätzens einer Oberfläche des Quarzprobestückes mit Flußsäure ist.

24. Analyseverfahren nach Anspruch 19,
wobei der zweite Schritt des chemischen Zersetzens der zu analysierenden Schicht, um ein Zersetzungsprodukt von dem Quarzprobestück abzutrennen, die Schritte umfaßt:
- Aufträufeln einer Zersetzungsflüssigkeit auf eine Oberfläche der freigelegten zu analysierenden Schicht;
- Halten der aufgeträufelten Zersetzungsflüssigkeit in Kontakt mit der freigelegten zu analysierenden Schicht für eine vorgeschriebene Zeitdauer zum Zersetzen; und
- Rückgewinnen der Zersetzungsflüssigkeit, in welcher die zu analysierende Schicht zersetzt und enthalten ist.

25. Analyseverfahren nach Anspruch 24,
wobei die Zersetzungsflüssigkeit nur Flußsäure oder eine Mischflüssigkeit aus Flußsäure und wenigstens einem Stoff der Gruppe Salpetersäure, Salzsäure, Schwefelsäure und Wasserstoffperoxid ist.

26. Analyseverfahren nach Anspruch 19,
wobei der dritte Schritt des Analysierens einer Kupfermenge in dem abgetrennten Zersetzungsprodukt mit Hilfe der Atom-Absorptionsspektroskopie, induktiv gekoppelter Plasma-Atomemissionsspektroskopie oder induktiv gekoppelter Plasma-Massenspektroskopie ausgeführt wird.

## Revendications

1. Elément en quartz pour équipement de fabrication de semiconducteur constitué d'un matériau de quartz,
dans lequel le matériau de quartz comprend une région de diffusion métallique d'une profondeur de 200 µm ou plus, le coefficient de diffusion du cuivre D étant de 5,8 10⁻¹⁰ cm²/s ou moins,
dans lequel le coefficient de diffusion du cuivre est obtenu par un procédé d'analyse du cuivre dans le matériau de quartz, le procédé d'analyse comprenant :
une première étape d'exposition d'une couche à analyser à une profondeur désirée dans un spécimen de quartz ;
une seconde étape de décomposition chimique de la couche à analyser pour séparer un produit de décomposition du spécimen de quartz ;
une troisième étape d'analyse d'une quantité de cuivre dans le produit de décomposition séparé ; et
une quatrième étape d'obtention d'un volume de la couche à analyser à partir d'un changement de volume entre les spécimens de quartz avant décomposition de la couche à analyser et après séparation de la décomposition de celle-ci.

2. Elément en quartz pour équipement de fabrication de semiconducteur selon la revendication 1, dans lequel, dans la quatrième étape d'obtention du volume de la couche à analyser dans le procédé d'analyse, le volume de la couche à analyser est calculé à partir d'un changement d'épaisseur entre les spécimens de quartz avant la décomposition de la couche à analyser et après séparation du produit de décomposition à obtenir.

3. Elément en quartz pour équipement de fabrication de semiconducteur selon la revendication 1, dans lequel, dans la quatrième étape d'obtention du volume de la couche à analyser dans le procédé d'analyse, le volume de la couche à analyser est calculé à partir d'un changement de poids entre les spécimens de quartz avant la décomposition de la couche à analyser et après séparation du produit de décomposition à obtenir.

4. Elément en quartz pour équipement de fabrication de semiconducteur selon l'une quelconque des revendications précédentes dans lequel le procédé d'analyse comprend en outre :
une cinquième étape d'exposition d'une nouvelle couche à analyser disposée plus à l'intérieur dans la direction de la profondeur que la couche analysée ; et
une sixième étape de répétition des deuxième à cinquième étapes pour obtenir une distribution de concentration du métal diffusé dans la direction de l'épaisseur du spécimen de quartz.

5. Elément en quartz pour équipement de fabrication de semiconducteur selon l'une quelconque des revendications 1 à 4, dans lequel la première et/ou la cinquième étape d'exposition de la couche à analyser dans le procédé d'analyse est une étape de gravure d'une surface du spécimen de quartz par de l'acide fluorhydrique.

6. Elément en quartz pour équipement de fabrication de semiconducteur selon l'une quelconque des revendications 1 à 5, dans lequel la seconde étape de décomposition chimique de la couche à analyser pour séparer un produit de décomposition du spécimen de quartz dans le procédé d'analyse comprend les étapes suivantes :
verser un liquide de décomposition sur une surface de la couche exposée à analyser ;
garder le liquide de décomposition versé en contact avec la couche exposée à analyser pendant une durée prescrite pour la décomposition ; et
récupérer le liquide de décomposition dans lequel la couche à analyser est décomposée et contenue.

7. Elément en quartz pour équipement de fabrication de semiconducteur selon l'une quelconque des revendications 1 à 6, dans lequel le liquide de décomposition est de l'acide fluorhydrique seul ou un mélange d'acide fluorhydrique et d'au moins un ou plusieurs produits choisis dans le groupe comprenant l'acide nitrique, l'acide chlorhydrique, l'acide sulfurique, et le peroxyde d'oxygène.

8. Elément en quartz pour équipement de fabrication de semiconducteur selon l'une quelconque des revendications 1 à 7, dans lequel la troisième étape d'analyse d'une quantité de cuivre dans le liquide de décomposition séparé dans le procédé d'analyse est effectuée par utilisation de spectroscopie d'absorption atomique, spectroscopie d'émission atomique par plasma à couplage inductif, ou spectroscopie de masse par plasma à couplage inductif.

9. Elément en quartz pour équipement de fabrication de semiconducteur selon l'une quelconque des revendications 1 à 8, dans lequel l'élément en quartz contient 60 µg/g ou moins du groupe hydroxy.

10. Elément en quartz pour équipement de fabrication selon l'une quelconque des revendications 1 à 9, dans lequel l'élément en quartz a été traité à une température dans la plage de 1050 à 1500° C.

11. Elément en quartz pour équipement de fabrication de semiconducteur selon l'une quelconque des revendications 1 à 10, dans lequel l'élément en quartz a une densité dans la plage de 2,2016 à 2,2027 g/cm³.

12. Elément en quartz pour équipement de fabrication de semiconducteur selon l'une quelconque des revendications 1 à 11, dans lequel l'élément en quartz contient 5 ng/g ou moins de cuivre.

13. Elément en quartz pour équipement de fabrication selon l'une quelconque des revendications 1 à 12, dans lequel l'élément en quartz est déformé par utilisation d'un procédé de fusion électrique.

14. Elément en quartz pour équipement de fabrication de semiconducteur selon l'une quelconque des revendications 1 à 13, dans lequel l'élément en quartz est utilisé pour un tube de four à verre en quartz.

15. Procédé de fabrication d'un élément en quartz pour équipement de fabrication de semiconducteur comprenant les étapes suivantes :
fabriquer un matériau en quartz de façon à comprendre 200 µm ou plus d'une région de diffusion métallique, le coefficient de diffusion du cuivre D étant de 5,8 10⁻¹⁰ cm²/s ou moins ; et
mouler le matériau de quartz formé dans le tube,
dans lequel le coefficient de diffusion du cuivre est obtenu par un procédé d'analyse du cuivre dans le matériau de quartz, le procédé d'analyse comprenant :
une première étape d'exposition d'une couche à analyser à une profondeur désirée dans un spécimen de quartz ;
une seconde étape de décomposition chimique de la couche à analyser pour séparer un produit de décomposition du spécimen de quartz ;
une troisième étape d'analyse d'une quantité de cuivre dans le produit de décomposition séparé ; et
une quatrième étape d'obtention d'un volume de la couche à analyser à partir d'un changement de volume entre les spécimens de quartz avant décomposition de la couche à analyser et après séparation de la décomposition de celle-ci.

16. Procédé de fabrication selon la revendication 15, dans lequel le procédé d'analyse comprend en outre :
une cinquième étape d'exposition d'une nouvelle couche à analyser disposée plus à l'intérieur dans la direction de la profondeur que la couche analysée ; et
une sixième étape de répétition des deuxième à cinquième étapes pour obtenir une distribution de concentration du métal diffusé dans la direction de l'épaisseur du spécimen de quartz.

17. Equipement de traitement thermique comprenant :
un corps définissant un espace de traitement thermique cylindrique s'étendant vers le haut et vers le bas ;
un tube de quartz recevant un substrat à traiter disposé dans l'espace de traitement thermique, étant constitué d'un matériau de quartz ayant 200 µm ou plus d'une région de diffusion de métal dont le coefficient de diffusion du cuivre D est de 5,8 10⁻¹⁰ cm²/s ou moins ;
un moyen de chauffage pour chauffer la surface externe du tube en quartz ;
un module d'alimentation en gaz pour fournir du gaz dans le tube en quartz ; et
un moyen de support pour maintenir de façon amovible dans le tube en quartz une pluralité de substrats à traiter dans un état mutuellement similaire,
dans lequel le coefficient de diffusion du cuivre est obtenu par un procédé d'analyse du cuivre dans le matériau de quartz, le procédé d'analyse comprenant :
une première étape d'exposition d'une couche à analyser à une profondeur désirée dans un spécimen de quartz ;
une seconde étape de décomposition chimique de la couche à analyser pour séparer un produit de décomposition du spécimen de quartz ;
une troisième étape d'analyse d'une quantité de cuivre dans le produit de décomposition séparé ; et
une quatrième étape d'obtention d'un volume de la couche à analyser à partir d'un changement de volume entre les spécimens de quartz avant décomposition de la couche à analyser et après séparation de la décomposition de celle-ci.

18. Equipement de traitement thermique selon la revendication 17, dans lequel le procédé d'analyse comprend en outre :
une cinquième étape d'exposition d'une nouvelle couche à analyser disposée plus à l'intérieur dans la direction de la profondeur que la couche analysée ; et
une sixième étape de répétition des deuxième à cinquième étapes pour obtenir une distribution de concentration du métal diffusé dans la direction de l'épaisseur du spécimen de quartz.

19. Procédé d'analyse pour obtenir un coefficient de diffusion du cuivre dans un élément en quartz comprenant :
une première étape d'exposition d'une couche à analyser à une profondeur désirée dans un spécimen de quartz ;
une seconde étape de décomposition chimique de la couche à analyser pour séparer un produit de décomposition du spécimen de quartz ;
une troisième étape d'analyse d'une quantité de cuivre dans le produit de décomposition séparé ; et
une quatrième étape d'obtention d'un volume de la couche à analyser à partir d'un changement de volume entre les spécimens de quartz avant décomposition de la couche à analyser et après séparation de la décomposition de celle-ci.

20. Procédé d'analyse selon la revendication 19, comprenant en outre :
une cinquième étape d'exposition d'une nouvelle couche à analyser disposée plus à l'intérieur dans la direction de la profondeur que la couche analysée ; et
une sixième étape de répétition des deuxième à cinquième étapes pour obtenir une distribution de concentration du métal diffusé dans la direction de l'épaisseur du spécimen de quartz.

21. Procédé d'analyse selon la revendication 19 ou 20, dans lequel, dans l'étape d'obtention du volume de la couche à analyser, le volume de la couche à analyser est calculé à partir d'un changement d'épaisseur entre les spécimens de quartz avant la décomposition de la couche à analyser et après séparation du produit de décomposition à obtenir.

22. Procédé d'analyse selon la revendication 19 ou 20, dans lequel, dans l'étape d'obtention du volume de la couche à analyser dans le procédé d'analyse, le volume de la couche à analyser est calculé à partir d'un changement de poids entre les spécimens de quartz avant la décomposition de la couche à analyser et après séparation du produit de décomposition à obtenir.

23. Procédé d'analyse selon la revendication 19 ou 20, dans lequel la première et/ou la cinquième étape d'exposition de la couche à analyser est une étape de gravure d'une surface du spécimen de quartz par de l'acide fluorhydrique.

24. Procédé d'analyse selon la revendication 19, dans lequel la seconde étape de décomposition chimique de la couche à analyser pour séparer un produit de décomposition du spécimen de quartz dans le procédé d'analyse comprend les étapes suivantes :
verser un liquide de décomposition sur une surface de la couche exposée à analyser ;
garder le liquide de décomposition versé en contact avec la couche exposée à analyser pendant une durée prescrite pour la décomposition ; et
récupérer le liquide de décomposition dans lequel la couche à analyser est décomposée et contenue.

25. Procédé d'analyse selon la revendication 24, dans lequel le liquide de décomposition est de l'acide fluorhydrique seul ou un mélange d'acide fluorhydrique et d'au moins un ou plusieurs choisis dans le groupe comprenant l'acide nitrique, l'acide chlorhydrique, l'acide sulfurique, et le peroxyde d'oxygène.

26. Procédé d'analyse selon la revendication 19, dans lequel la troisième étape d'analyse d'une quantité de cuivre dans le produit de décomposition séparé est effectuée par utilisation de spectroscopie d'absorption atomique, spectroscopie d'émission atomique par plasma à couplage inductif, ou spectroscopie de masse par plasma à couplage inductif.
